(19) Europäisches Patentamt
European Patent Office
Office européen des brevets

(11) **EP 4 535 968 A1**

(12) **EUROPEAN PATENT APPLICATION**
published in accordance with Art. 153(4) EPC

(43) Date of publication:
09.04.2025 Bulletin 2025/15

(51) International Patent Classification (IPC):
*H10K 39/12* (2023.01)     *H10K 30/40* (2023.01)
*H10K 30/88* (2023.01)

(21) Application number: 23811575.2

(22) Date of filing: 02.05.2023

(52) Cooperative Patent Classification (CPC):
H10K 30/40; H10K 30/88; H10K 39/12

(86) International application number:
PCT/JP2023/017170

(87) International publication number:
WO 2023/228698 (30.11.2023 Gazette 2023/48)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 25.05.2022 JP 2022085267

(71) Applicant: Kyocera Corporation
Kyoto-shi, Kyoto 612-8501 (JP)

(72) Inventors:
• SANO, Hirotaka
Kyoto-shi, Kyoto 612-8501 (JP)
• HONJO, Tomofumi
Kyoto-shi, Kyoto 612-8501 (JP)

(74) Representative: TBK
Bavariaring 4-6
80336 München (DE)

(54) **SOLAR CELL MODULE**

(57) A solar cell module (1) includes multiple cell areas (2) and a connector. Each of the cell areas (2) includes a solar cell element. The cell areas (2) are aligned in a first direction in a plane. The solar cell element generates power in response to incident light. The connector electrically connects, in series, the solar cell element in a cell area of the cell areas (2) to the solar cell element in another cell area of the cell areas (2). The solar cell element includes a first electrode layer, a second electrode layer, and a semiconductor layer (4b) between the first and second electrode layers. At least one of the cell areas (2) includes a physical portion (5) adjacent to the semiconductor layer (4b) when viewed in plan. The physical portion (5) includes an insulator or a semiconductor having a bandgap energy level different from a bandgap energy level of the semiconductor layer (4b).

FIG. 1

EP 4 535 968 A1

## Description

### CROSS-REFERENCE TO RELATED APPLICATION

This application claims priority to Japanese Patent Application No. 2022-085267 filed on May 25, 2022, the entire disclosure of which is incorporated herein by reference.

### TECHNICAL FIELD

The present disclosure relates to a solar cell module.

### BACKGROUND OF INVENTION

Solar cells include crystalline solar cells and thin-film solar cells. A thin-film solar cell typically includes multiple solar cell elements aligned on a substrate and electrically connected to one another in series (refer to, for example, Patent Literature 1).

### CITATION LIST

### PATENT LITERATURE

Patent Literature 1: Japanese Unexamined Patent Application Publication No. 2007-012976

### SUMMARY

One or more aspects of the present disclosure are directed to a solar cell module.

In one embodiment, a solar cell module includes a plurality of cell areas and a connector. Each of the plurality of cell areas includes a solar cell element. The plurality of cell areas is aligned in a first direction in a plane. The solar cell element generates power in response to incident light. The connector electrically connects, in series, the solar cell element in a cell area of the plurality of cell areas to the solar cell element in another cell area of the plurality of cell areas. The solar cell element includes a first electrode layer, a second electrode layer, and a semiconductor layer between the first electrode layer and the second electrode layer. At least one of the plurality of cell areas includes a physical portion. The physical portion is adjacent to the semiconductor layer when viewed in plan. The physical portion includes an insulator or a semiconductor having a bandgap energy level different from a bandgap energy level of the semiconductor layer.

In another embodiment, a solar cell module includes a plurality of cell areas, a connector, and a member. Each of the plurality of cell areas includes a solar cell element. The plurality of cell areas is aligned in a first direction in a plane. The solar cell element generates power in response to incident light. The connector electrically connects, in series, the solar cell element in a cell area of the plurality of cell areas to the solar cell element in another cell area of the plurality of cell areas. The member overlaps a first area in at least one of the plurality of cell areas and does not overlap a second area in the at least one of the plurality of cell areas when viewed in plan. The member absorbs, of the incident light, a portion with at least a partial wavelength range of the incident light.

In another embodiment, a solar cell module includes a plurality of cell areas, a connector, and a member. Each of the plurality of cell areas includes a solar cell element. The plurality of cell areas is aligned in a first direction in a plane. The solar cell element generates power in response to incident light. The connector electrically connects, in series, the solar cell element in a cell area of the plurality of cell areas to the solar cell element in another cell area of the plurality of cell areas. The member overlaps a first area in at least one of the plurality of cell areas excluding outer two cell areas of the plurality of cell areas in the first direction and does not overlap a second area in the at least one of the plurality of cell areas when viewed in plan. The member reflects, of the incident light, a portion with at least a partial wavelength range of the incident light.

### BRIEF DESCRIPTION OF THE DRAWINGS

FIG. 1 is a schematic plan view of a solar cell module with an example structure according to a first embodiment.
FIG. 2 is a schematic cross-sectional view of the solar cell module taken along line II-II in FIG. 1.
FIG. 3 is a schematic cross-sectional view of the solar cell module taken along line III-III in FIG. 1.
FIG. 4 is a schematic cross-sectional view of an example solar cell module during manufacture.
FIG. 5 is a schematic cross-sectional view of an example solar cell module during manufacture.
FIG. 6 is a schematic cross-sectional view of an example solar cell module during manufacture.
FIG. 7 is a schematic cross-sectional view of an example solar cell module during manufacture.
FIG. 8 is a schematic cross-sectional view of an example solar cell module during manufacture.
FIG. 9 is a schematic cross-sectional view of an example solar cell module during manufacture.
FIG. 10 is a schematic cross-sectional view of an example solar cell module according to a second embodiment.
FIG. 11 is a schematic cross-sectional view of the solar cell module taken along line XI-XI in FIG. 10.
FIG. 12 is a graph showing an example of wavelength dependency of absorbance in light-absorbing layers.
FIG. 13 is a schematic cross-sectional view of an example solar cell module according to a third embodiment.

FIG. 14 is a schematic cross-sectional view of the solar cell module taken along line XIV-XIV in FIG. 13 in a first example.

FIG. 15 is a schematic cross-sectional view of the solar cell module taken along line XIV-XIV in FIG. 13 in a second example.

FIG. 16 is a schematic cross-sectional view of the solar cell module taken along line XIV-XIV in FIG. 13 in a third example.

FIG. 17 is a schematic cross-sectional view of an example solar cell module according to a fourth embodiment.

FIG. 18 is a schematic cross-sectional view of the solar cell module taken along line XVIII-XVIII in FIG. 17.

FIG. 19 is a schematic cross-sectional view of the solar cell module taken along line XIX-XIX in FIG. 17.

FIG. 20 is a schematic cross-sectional view of the solar cell module taken along line XIX-XIX in FIG. 17 in a first variation.

FIG. 21 is a schematic cross-sectional view of the solar cell module taken along line XIX-XIX in FIG. 17 in a second variation.

FIG. 22 is a schematic cross-sectional view of the solar cell module taken along line XIX-XIX in FIG. 17 in a third variation.

FIG. 23 is a schematic cross-sectional view of the solar cell module taken along line XIX-XIX in FIG. 17 in a fourth variation.

FIG. 24 is a cross-sectional view of the solar cell module taken along line XIX-XIX in FIG. 17, illustrating the structure in a fifth variation.

FIG. 25 is a schematic cross-sectional view of the solar cell module taken along line XIX-XIX in FIG. 17 in a sixth variation.

DESCRIPTION OF EMBODIMENTS

The inventors have devised a technique for improving the design of a solar cell module. First to fourth embodiments for such a technique will now be described with reference to the drawings.

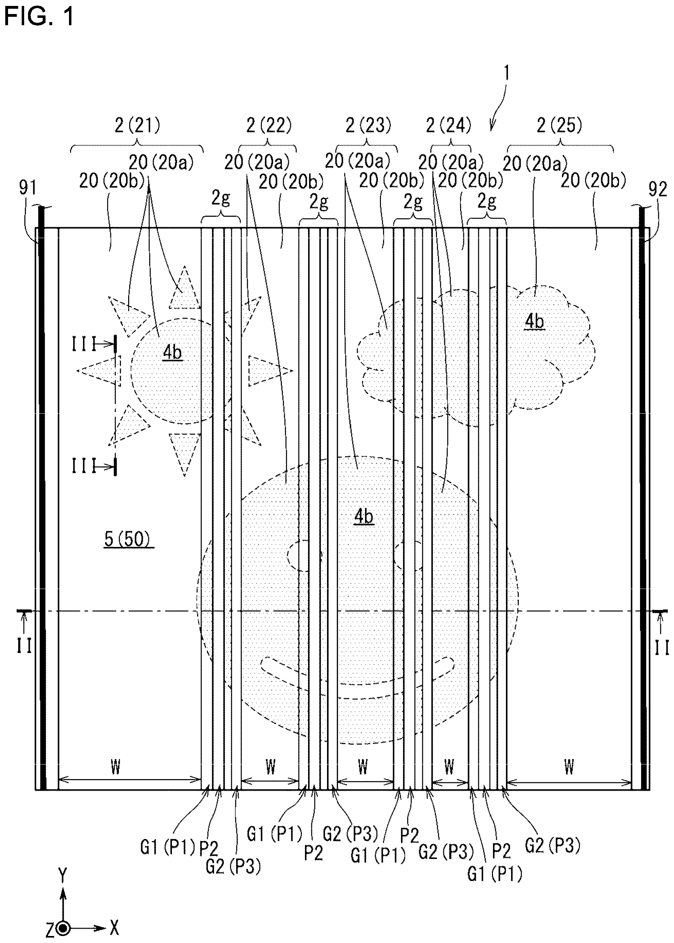

Embodiments of the present disclosure will be described below with reference to the drawings. In the drawings, like reference numerals denote the components with like or similar structures and functions. Such components will not be described repeatedly. The drawings are schematic. FIGs. 1 to 24 illustrate a right-handed XYZ coordinate system. In the XYZ coordinate system, the direction in which multiple solar cell elements 4 are aligned is a positive X-direction, the longitudinal direction of a third groove P3 between adjacent ones of the solar cell elements 4 is a positive Y-direction, and the direction perpendicular to both the positive X-direction and the positive Y-direction is a positive Z-direction.

1. First Embodiment

1-1. Overview of Solar Cell Module

A solar cell module 1 according to a first embodiment will now be described with reference to FIGs. 1 to 3.

As illustrated in FIG. 1, the solar cell module 1 includes multiple cell areas 2. The multiple cell areas 2 are aligned in a first direction (positive X-direction) in a plane when viewed in plan. In the example in FIG. 1, the multiple cell areas 2 are five cell areas including a first cell area 21 to a fifth cell area 25. The first cell area 21 to the fifth cell area 25 are aligned in this order from the negative X-direction to the positive X-direction. More specifically, the first cell area 21 is an outermost cell area in the negative X-direction, and the fifth cell area 25 is an outermost cell area in the positive X-direction. An intercellular area 2g is between the first cell area 21 and the second cell area 22. The intercellular area 2g is also between the other cell areas 2.

Each of the cell areas 2 is a strip with its longitudinal direction parallel to a second direction (positive Y-direction) perpendicular to the first direction. The cell areas 2 may have, for example, the same length in the Y-direction. The cell areas 2 may have, for example, widths W different from one another in the X-direction. The widths W of the respective cell areas 2 will be described in detail later.

Each of the cell areas 2 includes a corresponding one of the solar cell elements 4 that generate power in response to incident light such as sunlight as described later. As described later, the solar cell elements 4 in the cell areas 2 electrically connect to one another in series. The solar cell element 4 in the outermost first cell area 21 of the cell areas 2 in the negative X-direction is electrically connected to first wiring 91 for outputting power. The solar cell element 4 in the outermost fifth cell area 25 of the cell areas 2 in the positive X-direction is electrically connected to second wiring 92 for outputting power. The solar cell elements 4 in the multiple cell areas 2 are connected in series to one another. The direct currents flowing through the cell areas 2 are thus equal to one another. The direct currents are output outside the solar cell module 1 through the first wiring 91 and the second wiring 92.

In the present embodiment, at least one of the multiple cell areas 2 includes multiple sub-areas 20. The multiple sub-areas 20 are adjacent to one another when viewed in plan. The multiple sub-areas 20 have current densities different from one another. In other words, at least one of the cell areas 2 has a current density distribution when viewed in plan. The current density in this case is a current per unit area size. In the example in FIG. 1, each of the first cell area 21 to the fifth cell area 25 includes first sub-areas 20a and second sub-areas 20b as the multiple sub-areas 20. In other words, in the example in FIG. 1, the first sub-areas 20a and the second sub-areas 20b are included in each of the cell areas 2. Note that, in the example in FIG. 1, the first sub-areas 20a are hatched with a dot pattern.

As illustrated in FIG. 1, in each of the cell areas 2, at least a part of one of the sub-areas 20 (e.g., the first sub-areas 20a) and at least a part of another one of the sub-areas 20 (e.g., the second sub-areas 20b) are aligned in the Y-direction. In each of the cell areas 2, for example, at least a part of one of the sub-areas 20 and at least a part of another one of the sub-areas 20 may be aligned in the X-direction.

In this example, the first sub-areas 20a have a higher current density than the second sub-areas 20b. Note that the current density may include zero. In other words, a part of the cell areas 2 (the second sub-areas 20b in this example) may have no current being generated.

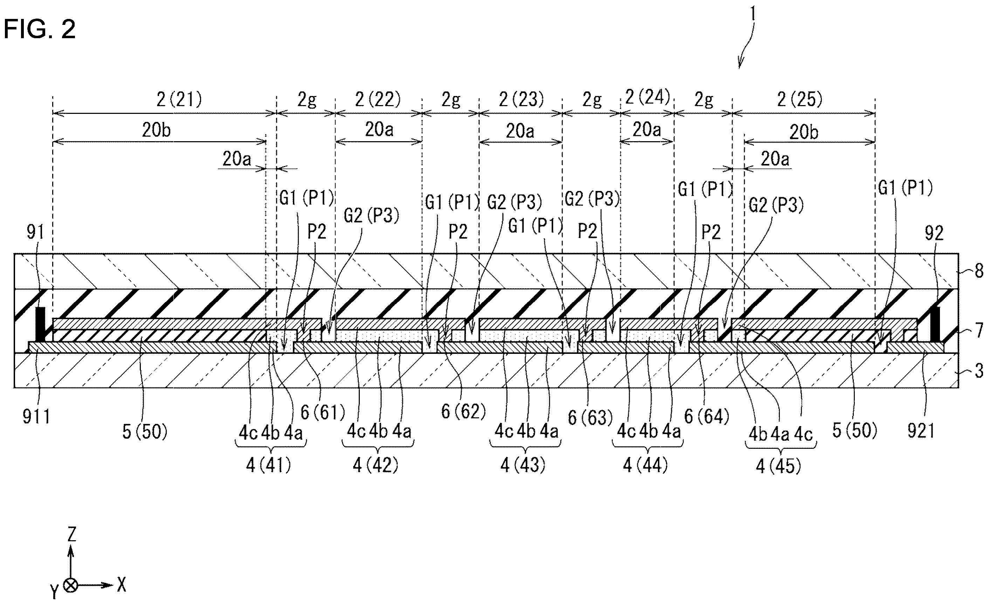

As illustrated in FIGs. 1 to 3, each of the cell areas 2 is defined by, for example, the corresponding solar cell element 4 and a physical portion 5. In the example in FIG. 2, the multiple solar cell elements 4 include a first solar cell element 41 to a fifth solar cell element 45 corresponding respectively to the first cell area 21 to the fifth cell area 25. The solar cell elements 4 are each located in the first sub-areas 20a in the corresponding one of the cell areas 2. In response to incident light, each of the solar cell elements 4 generates carriers including electrons or holes. The multiple solar cell elements 4 are connected to one another in series with connectors 6. Thus, a predetermined amount of carriers generated by the solar cell element 4 in each of the cell areas 2 flows through the multiple cell areas 2 as a direct current.

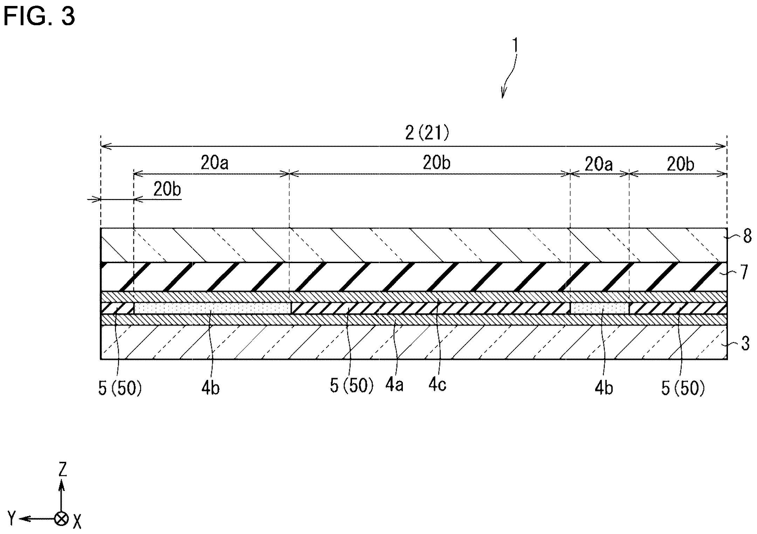

The physical portion 5 is in the second sub-areas 20b in each of the cell areas 2. As illustrated in FIG. 3, the physical portion 5 is, for example, adjacent to a semiconductor layer 4b (described later) in the solar cell element 4 in each of the cell areas 2. The physical portion 5 may be made of a material different from the material of the semiconductor layer 4b in the solar cell element 4. Thus, for example, the semiconductor layer 4b and the physical portion 5 have bandgap energy levels different from each other. The physical portion 5 may be, for example, an insulating layer 50. The insulating layer 50 may be made of, for example, a transparent insulating material such as silicon oxide. The physical portion 5 being the insulating layer 50 generates substantially no carriers that can be output.

In the example in FIGs. 1 to 3, each of the cell areas 2 includes the first sub-areas 20a and the second sub-areas 20b. In each of the cell areas 2, the semiconductor layer 4b is in the first sub-areas 20a, and the physical portion 5 is in the second sub-areas 20b. In this example, the semiconductor layer 4b and the physical portion 5 having different bandgap energy levels have different degrees of light absorption. Thus, the first sub-areas 20a and the second sub-areas 20b apparently show different colors when a user views the solar cell module 1.

In the example in FIG. 1, the first sub-areas 20a collectively correspond to a design area resembling a sun, a design area resembling a cloud, and a design area resembling a smiling face. The second sub-areas 20b collectively correspond to the background area of these design areas. The user can thus visually identify the designs of the sun, the cloud, and the smiling face when viewing the solar cell module 1 in plan.

1-2. Specific Structure of Solar Cell Module

As illustrated in FIGs. 2 and 3, the solar cell module 1 includes, for example, a first substrate 3, the multiple solar cell elements 4, the physical portion 5, the connectors 6, a filler 7, a second substrate 8, the first wiring 91, and the second wiring 92. The first substrate 3 and the second substrate 8 face each other in the Z-direction. The solar cell elements 4, the physical portion 5, the connectors 6, the filler 7, the first wiring 91, and the second wiring 92 are between the first substrate 3 and the second substrate 8 and are joined together with the filler 7.

1-2-1. First Substrate

The first substrate 3 can support and protect the multiple solar cell elements 4. The solar cell elements 4 are on a surface of the first substrate 3. When the first substrate 3 is transmissive to light in a specific wavelength range, the light transmitted through the first substrate 3 may be incident on the multiple solar cell elements 4. The first substrate 3 is, for example, a flat plate including a rectangular plate surface. The first substrate 3 includes one side extending in, for example, the positive X-direction. The first substrate 3 made of, for example, glass or a resin such as an acrylic resin or a polycarbonate resin may be transmissive to light in the specific wavelength range. Examples of the glass include white plate glass, tempered glass, and heat-reflective glass with high light transmissivity. The first substrate 3 may be flexible. The light in the specific wavelength range herein refers to light in a wavelength range that is photoelectrically convertible by the solar cell elements 4.

The solar cell module 1 may be installed with, for example, the first substrate 3 facing a light source. The light source is, for example, the sun. The solar cell module 1 is placed with, for example, the first substrate 3 facing the sun at solar noon. In this case, the first substrate 3 may be made of a light-transmissive material.

The solar cell module 1 may also be installed with the second substrate 8 facing the light source. In this case, the second substrate 8 is light-transmissive, whereas the first substrate 3 may or may not be light-transmissive. For example, the first substrate 3 may be a metal plate including an insulating layer on the surface of the first substrate 3.

In the example described below, the solar cell module 1 is installed with the first substrate 3 facing a light source. In this case, the incident light such as the sunlight transmitted through the first substrate 3 is incident on the multiple solar cell elements 4. 1-2-2. Solar Cell Elements and Physical Portion

The multiple solar cell elements 4 are aligned in the positive X-direction in a plane. Being aligned in a plane refers to the state in which the multiple solar cell elements 4 are located along an imaginary or a physical plane side by side. In the example in FIG. 2, the multiple solar cell elements 4 are aligned along the surface of the first substrate 3.

Each of the solar cell elements 4 includes a first electrode layer 4a, the semiconductor layer 4b, and a second electrode layer 4c. The first electrode layer 4a is on the first substrate 3. The semiconductor layer 4b is on the first electrode layer 4a. The second electrode layer 4c is on the semiconductor layer 4b. In other words, the first electrode layer 4a, the semiconductor layer 4b, and the second electrode layer 4c are stacked in this order in the Z-direction.

The first electrode layer 4a is more transmissive to light in a specific wavelength range than the semiconductor layer 4b. The first electrode layer 4a may be made of, for example, transparent conductive oxide (TCO) that is transmissive to light in the specific wavelength range. Examples of the TCO include indium tin oxide (ITO), fluorine-doped tin oxide (FTO), and zinc oxide (ZnO).

The incident light transmitted through the first substrate 3 and the first electrode layer 4a is incident on the semiconductor layer 4b. The semiconductor layer 4b absorbs the light to generate carriers including holes or electrons. The resultant carriers flow toward one of the first electrode layer 4a or the second electrode layer 4c.

Note that the first electrode layer 4a may not be light-transmissive when the solar cell module 1 is installed with the second substrate 8 facing the light source. For example, the first electrode layer 4a may be made of any of various metals.

In the present embodiment, five sections of the first electrode layer 4a are aligned sequentially in a plane on the first substrate 3 in the positive X-direction. Two sections of the first electrode layer 4a respectively in two adjacent solar cell elements 4 are aligned across a gap G1 (also referred to as a first gap). For example, the section of the first electrode layer 4a in the first solar cell element 41 and the section of the first electrode layer 4a in the second solar cell element 42 are aligned across the first gap G1. The first gap G1 is elongated with its longitudinal direction parallel to the positive Y-direction. A first groove P1 is also defined by the first substrate 3 as a bottom surface and two end faces of two sections of the first electrode layer 4a facing across the first gap G1 as side surfaces. The first groove P1 extends straight in the positive Y-direction.

The first electrode layer 4a extends over at least the entire first sub-areas 20a in each of the cell areas 2. The first electrode layer 4a may extend, for example, over the entire second sub-areas 20b in addition to the first sub-areas 20a. In other words, the first electrode layer 4a may extend over the entire cell areas 2. Each section of the first electrode layer 4a extends beyond the corresponding cell area 2 in the negative X-direction, and the extended portion is located in the corresponding intercellular area 2g. The first electrode layer 4a is a strip when viewed in plan, for example. The first electrode layer 4a has, for example, substantially the same length in the Y-direction as the cell areas 2.

In each of the solar cell elements 4, the semiconductor layer 4b is between the first electrode layer 4a and the second electrode layer 4c. The semiconductor layer 4b extends over the entire first sub-areas 20a when viewed in plan. The semiconductor layer 4b includes, for example, a layer (a perovskite layer) of a semiconductor (also referred to as a perovskite semiconductor) with a perovskite structure and a hole transport layer (HTL) stacked on each other. For the semiconductor layer 4b including the perovskite semiconductor, light in the specific wavelength range includes visible light and infrared light.

The perovskite semiconductor may include, for example, an organic and inorganic halide perovskite semiconductor. A semiconductor with the perovskite structure including an amine group as the perovskite semiconductor can improve photoelectric conversion efficiency of the semiconductor layer 4b. This may improve the photoelectric conversion efficiency of the solar cell elements 4. Examples of the perovskite semiconductor with the perovskite structure including an amine group include a halide perovskite semiconductor with an $ABX_3$ composition in which an A ion, a B ion, and an X ion are bonded. Examples of the A ion may include an organic cation including an amine group such as a methylammonium ion ($MA^+$), a formamidinium ion ($FA^+$), and a guanidinium ion ($GA^+$). Examples of the B ion may include a metal ion of a group 14 (group IV-A) element such as a lead ion ($Pb^{2+}$) and a tin ion ($Sn^{2+}$). Example of the X ion may include a halide ion such as an iodine ion ($I^-$), a bromine ion ($Br^-$), and a chloride ion ($Cl^-$).

The perovskite semiconductor may be formed by, for example, applying a liquid material onto the first electrode layer 4a on the first substrate 3 and drying the liquid material. In this case, the perovskite semiconductor is a crystalline thin film. For example, the first gap G1 is also filled with the liquid material to have a part of the perovskite semiconductor formed in the first gap G1 after drying. The liquid material can be prepared by, for example, dissolving halide alkylamine and halide lead as the materials in a solvent.

The HTL can collect and output holes. The HTL is made of, for example, spiro-OMeTAD, which is a soluble diamine derivative.

In this example, the perovskite semiconductor may be an intrinsic semiconductor (i-type semiconductor), the HTL may be a p-type semiconductor, and the TCO in the first electrode layer 4a may be an n-type semiconductor, defining a PIN junction area. In the PIN junction area, photoelectric conversion in response to light generates power. The semiconductor layer 4b may include, for example, an n-type semiconductor layer between the perovskite semiconductor layer and the first electrode layer 4a. In this case, the semiconductor layer 4b alone may define the PIN junction area.

The physical portion 5 is adjacent to the semiconductor layer 4b in the solar cell element 4 in each of the cell areas 2. In other words, the physical portion 5 is in the same layer as the semiconductor layer 4b. As illustrated in FIGs. 2 and 3, the physical portion 5 extends, for example, over the entire second sub-areas 20b. In the example in FIGs. 2 and 3, the physical portion 5 is between the first electrode layer 4a and the second electrode layer 4c and is in contact with the side surfaces of the semiconductor layer 4b. The physical portion 5 can support the second electrode layer 4c together with the semiconductor layer 4b.

The physical portion 5 has a bandgap energy level different from the bandgap energy level of the semiconductor layer 4b. The difference in bandgap energy level between the physical portion 5 and the semiconductor layer 4b may be, for example, 0.1 eV or more, 0.2 eV or more, or 0.5 eV or more. The bandgap energy level of the semiconductor layer 4b or the physical portion 5 may be, for example, 1.7 eV or more. The physical portion 5 may be, for example, the insulating layer 50 including an insulator. The insulating layer 50 may be made of, for example, any of various insulators such as silicon oxide or a resin. The insulating layer 50 may be transmissive to visible light. In other words, the insulating layer 50 may be transparent or semitransparent. In the second sub-areas 20b in each of the cell areas 2, the insulating layer 50 is between the first electrode layer 4a and the second electrode layer 4c to avoid short-circuiting between the first electrode layer 4a and the second electrode layer 4c.

The semiconductor layer 4b and the insulating layer 50 may also be located in the intercellular areas 2g. In FIG. 1, for example, in the first groove P1 in each of the intercellular areas 2g, some of the first sub-areas 20a and some of the second sub-areas 20b are adjacent to one another in the Y-direction. In each of the intercellular areas 2g, the first sub-areas 20a and the second sub-areas 20b are adjacent to one another in the Y-direction in an area between a second groove P2 (described later) and the third groove P3 (described later). In each of the intercellular areas 2g, the semiconductor layer 4b may be in the first sub-areas 20a, and the insulating layer 50 may be in the second sub-areas 20b. Thus, in each of the intercellular areas 2g (in particular, in the first groove P1 and in the area between the second groove P2 and the third groove P3), the insulating layer 50 is adjacent to the semiconductor layer 4b in the Y-direction.

In each of the solar cell elements 4, the second electrode layer 4c is on the semiconductor layer 4b and the insulating layer 50. The second electrode layer 4c may be highly transmissive to light in the specific wavelength range. For example, the second electrode layer 4c may be made of, for example, TCO that is transmissive to light in the specific wavelength range. Examples of the TCO may include ITO, FTO, and ZnO. In this case, light transmitted through the solar cell elements 4 and reflected from the second substrate 8 or from an external member may be transmitted through the second electrode layer 4c again and may be incident on the semiconductor layer 4b. This may improve the photoelectric conversion efficiency of the solar cell module 1. Note that the second electrode layer 4c may or may not be light-transmissive, and may be made of, for example, a metal. When the second electrode layer 4c is made of a metal, light transmitted through the semiconductor layer 4b is reflected from the second electrode layer 4c, allowing the reflected light to be incident on the semiconductor layer 4b. This may improve the photoelectric conversion efficiency of the solar cell module 1.

In the first embodiment, five sections of the second electrode layer 4c are aligned sequentially in a plane in the positive X-direction. In this example, sections of the second electrode layer 4c respectively in two adjacent solar cell elements 4 are aligned across a gap G2 (also referred to as a second gap). For example, the section of the second electrode layer 4c in the first solar cell element 41 and the section of the second electrode layer 4c in the second solar cell element 42 are aligned across the second gap G2. The second gap G2 is, for example, elongated with its longitudinal direction parallel to the positive Y-direction. The second gap G2 includes the third groove P3 defined by the first electrode layer 4a as a bottom surface and two end faces of two solar cell elements 4 facing across the second gap G2 as side surfaces. The third groove P3 extends through the second electrode layer 4c, the semiconductor layer 4b, and the insulating layer 50 in the Z-direction and extends straight in the positive Y-direction.

The second electrode layer 4c extends over at least the entire first sub-areas 20a in each of the cell areas 2. The second electrode layer 4c may extend, for example, over the entire second sub-areas 20b in addition to the first sub-areas 20a. In other words, the second electrode layer 4c may extend over the entire cell areas 2. Each section of the second electrode layer 4c extends beyond the corresponding cell area 2 in the positive X-direction, and the extended portion is located in the corresponding intercellular area 2g. In each of the intercellular areas 2g, the third groove P3 between the sections of the second electrode layer 4c is located farther in the positive X-direction than the first groove P1 between the sections of the first electrode layer 4a. In each of the intercellular areas 2g, an end portion of the section of the first electrode layer 4a in the negative X-direction and an end portion of the section of the second electrode layer 4c in the positive X-direction overlap each other when viewed in plan. The semiconductor layer 4b or the physical portion 5 is between the end portion of the section of the first electrode layer 4a and the end portion of the section of the second electrode layer 4c. The second electrode layer 4c is a strip when viewed in plan, for example. The second electrode layer 4c has, for example, substantially the same length in the Y-direction as the cell areas 2.

Each of the intercellular areas 2g is defined between, for example, an edge of the first groove P1 in the negative X-direction and an edge of the third groove P3 in the positive X-direction. In the intercellular areas 2g, the solar cell elements 4 in adjacent cell areas 2 are electrically connected with one of the connectors 6 (described later). Each of the cell areas 2 is defined between, for example, the edge of the third groove P3 in the positive X-direction and the edge of the first groove P1 in the negative X-direction.

1-2-3. Connector

Each of the multiple connectors 6 is located in the corresponding intercellular area 2g to connect the first electrode layer 4a and the second electrode layer 4c in two adjacent solar cell elements 4. In the example in FIG. 2, the multiple connectors 6 include a first connector 61 to a fourth connector 64. In the example in FIG. 2, the first connector 61 electrically connects the second electrode layer 4c in the first solar cell element 41 and the first electrode layer 4a in the second solar cell element 42. The second connector 62 electrically connects the second electrode layer 4c in the second solar cell element 42 and the first electrode layer 4a in the third solar cell element 43. The third connector 63 electrically connects the second electrode layer 4c in the third solar cell element 43 and the first electrode layer 4a in the fourth solar cell element 44. The fourth connector 64 electrically connects the second electrode layer 4c in the fourth solar cell element 44 and the first electrode layer 4a in the fifth solar cell element 45. The multiple solar cell elements 4 may thus be electrically connected in series.

For example, the connectors 6 are made of the same material as the second electrode layer 4c integrally. Each of the connectors 6 fills the corresponding second groove P2 between the first groove P1 and the third groove P3 and is in contact with the first electrode layer 4a on a bottom surface of the second groove P2. Thus, the connectors 6 electrically connect the first electrode layer 4a and the second electrode layer 4c. The second groove P2 is, for example, elongated with its longitudinal direction parallel to the positive Y-direction. The second groove P2 also extends straight in the positive Y-direction.

1-2-4. Output Electrode

The first electrode layer 4a in the first solar cell element 41 includes an end portion 911 extending farther in the negative X-direction than the insulating layer 50 and the semiconductor layer 4b. The first wiring 91 with a first polarity for output is located on the end portion 911. The first wiring 91 is made of a metal such as copper. The first wiring 91 may be, for example, copper foil. For example, a joint such as solder may be between the first wiring 91 and the end portion 911. The first wiring 91 is electrically connected to the end portion 911. As illustrated in FIG. 1, the first wiring 91 is elongated with its longitudinal direction parallel to the positive Y-direction.

In the example in FIG. 2, an electrode layer 921 is located farther in the positive X-direction than the first electrode layer 4a in the fifth solar cell element 45. The first groove P1 is between the electrode layer 921 and the first electrode layer 4a in the fifth solar cell element 45. The electrode layer 921 is made of, for example, the same material as the first electrode layer 4a. The electrode layer 921 is elongated with its longitudinal direction parallel to the positive Y-direction when viewed in plan. The electrode layer 921 is electrically connected to the second electrode layer 4c in the fifth solar cell element 45. The second wiring 92 with a second polarity for output is located on the electrode layer 921. The second wiring 92 is made of a metal such as copper. The second wiring 92 may be, for example, copper foil. For example, a joint such as solder may be between the second wiring 92 and the electrode layer 921. The second wiring 92 is electrically connected to the electrode layer 921. As illustrated in FIG. 1, the second wiring 92 is elongated with its longitudinal direction parallel to the positive Y-direction. In this example, when the first polarity is negative, the second polarity is positive. For example, when the first polarity is positive, the second polarity is negative.

1-2-5. Second Substrate

The second substrate 8 can protect the multiple solar cell elements 4. The second substrate 8 faces the first substrate 3 in the Z-direction. The second substrate 8 is, for example, a flat plate, which is the same as or similar to the first substrate 3. The flat plate includes a rectangular plate surface. The second substrate 8 may have the same shape as the first substrate 3 when viewed in plan. The second substrate 8 may or may not be transmissive to light in a specific wavelength range. The second substrate 8 made of, for example, glass or a resin such as an acrylic resin or a polycarbonate resin may be transmissive to light in the specific wavelength range. Alternatively, the second substrate 8 may be a metal plate including an insulating layer on a surface of the second substrate 8. In this case, the second substrate 8 is not light-transmissive. Note that the second substrate 8 is made of a light-transmissive material when the solar cell module 1 is installed with the second substrate 8 facing the light source. The second substrate 8 may be flexible, in the same manner as the first substrate 3.

1-2-6. Filler

The insulating filler 7 is between the first substrate 3 and the second substrate 8 and covers the multiple solar cell elements 4, the insulating layer 50, the first wiring 91, and the second wiring 92. In other words, the filler 7 fills a gap between the first substrate 3 and the second substrate 8. The filler 7 is, for example, transmissive to light in a specific wavelength range. The filler 7 may be made of, for example, a polyvinyl acetal or an acid-modified resin, such as ethylene-vinyl acetate (EVA) or polyvinyl butyral (PVB). For example, the filler 7 made of, for example, EVA, which is relatively inexpensive, can easily protect the multiple solar cell elements 4. The acid-modified resin is, for example, a modified polyolefin resin formed by graphitically modifying a polyolefin resin with an acid. Examples of the acid usable for graphitically modifying an acid-modified resin include an acrylic acid, a methacrylic acid, a maleic acid, a fumaric acid, an itaconic acid, maleic anhydride, hemic anhydride, itaconic anhydride, and citraconic anhydride.

### 1-2-7. Area Size of Cell Area

In the above specific example, each of the first sub-areas 20a in each of the cell areas 2 includes the first electrode layer 4a, the semiconductor layer 4b, and the second electrode layer 4c stacked on one another. Thus, in the first sub-areas 20a, carriers are generated in response to incident light, and a predetermined amount of the carriers flows as a direct current. Each of the second sub-areas 20b in each of the cell areas 2 includes the insulating layer 50 without including the semiconductor layer 4b. Thus, in the second sub-areas 20b, no carriers that can be output are substantially generated, and no current substantially flows. In other words, the current density of the direct current generated in the first sub-areas 20a is higher than the current density (= 0) in the second sub-areas 20b.

The amount of carriers generated per unit time in each of the cell areas 2 will now be described. Each of the cell areas 2 with larger area sizes of the first sub-areas 20a has a larger amount of carriers generated per unit time. However, the solar cell elements 4 in the multiple cell areas 2 are connected in series to one another, causing the predetermined amount of the generated carriers alone to flow as a direct current. In other words, the portion of the carriers exceeding the predetermined amount cannot be externally output from the solar cell module 1. Thus, a greater variation in the amount of carriers generated per unit time among the multiple cell areas 2 increases carrier portions that cannot be externally output, decreasing the photoelectric conversion efficiency of the solar cell module 1.

The structure in this example is designed to reduce a variation in the amount of carriers generated per unit time among the multiple cell areas 2. Note that the amount of carriers generated per unit time in each of the cell areas 2 is hereafter also referred to as a carrier generation amount.

As illustrated in FIG. 1, the cell areas 2 with larger area sizes of the second sub-areas 20b (specifically, the area size of the insulating layer 50 when viewed in plan) may have greater widths W. In other words, the cell areas 2 with larger area sizes of the second sub-areas 20b have larger area sizes. In the example in FIG. 1, the second sub-areas 20b in the first cell area 21 are larger than the second sub-areas 20b in the second cell area 22, and the width W of the first cell area 21 is greater than the width W of the second cell area 22. This reduces the difference between the area size of the first sub-areas 20a in the first cell area 21 and the area size of the first sub-areas 20a in the second cell area 22. In other words, a variation in the area size of the first sub-areas 20a among the multiple cell areas 2 can be reduced. This thus reduces a variation in the carrier generation amount among the multiple cell areas 2.

In other words, the width W of each of the cell areas 2 may be set as described below. More specifically, the width W of each of the cell areas 2 is set to achieve a smaller variation in the carrier generation amount than in an imaginary structure in which the multiple cell areas 2 have the same width. In a more specific example, the width W of each of the cell areas 2 is set to satisfy the formula below.

$$J \cdot r[k] \cdot A[k] = \text{constant} \qquad (1)$$

In this formula, J is the carrier generation amount per unit area size and per unit time in the first sub-areas 20a while incident light is incident on the solar cell module 1 with a uniform spatial distribution, A[k] is the area size of a k-th cell area 2, and r[k] is the ratio of the area size of the first sub-areas 20a in the k-th cell area 2 to the area size A[k]. When the cell areas 2 are rectangular, the area size A[k] is the product of a length of the k-th cell area 2 in the Y-direction and a width W of the k-th cell area 2 in the X-direction. The left side of Formula 1 indicates the carrier generation amount in each of the cell areas 2. Thus, Formula 1 allows the width W of each of the cell areas 2 to be set to achieve a constant carrier generation amount among the multiple cell areas 2.

The width W of each of the cell areas 2 that is set as described above can reduce a variation in the carrier generation amount among the multiple cell areas 2. This allows the direct current to be output more efficiently from the solar cell module 1. In other words, a greater amount of direct current can be output from the solar cell module 1 to improve the photoelectric conversion efficiency of the solar cell module 1.

### 1-3. Method for Manufacturing Solar Cell Module

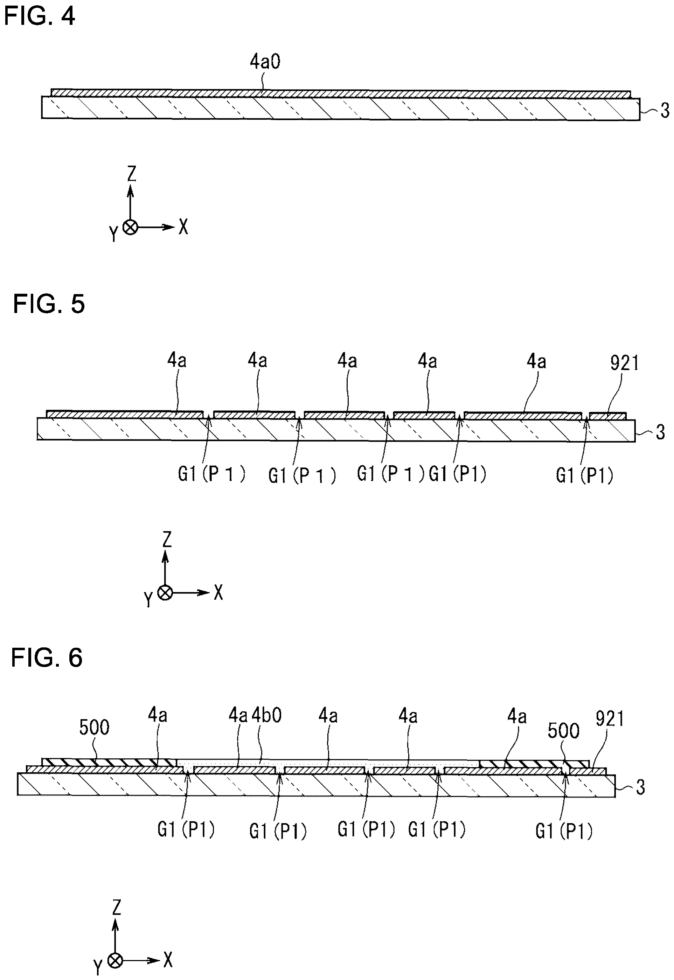

A method for manufacturing the solar cell module 1 will now be described with reference to FIGs. 4 to 9. As illustrated in FIG. 4, the first substrate 3 is prepared first. The first substrate 3 is, for example, a rectangular flat plate that is transmissive to light in the specific wavelength range. An electrode layer 4a0 is then formed on one surface of the first substrate 3. The electrode layer 4a0 may be formed with, for example, a film deposition method such as sputtering, vapor deposition, or chemical vapor deposition. The electrode layer 4a0 may be made of, for example, TCO such as ITO, FTO, or ZnO. The electrode layer 4a0 may have, for example, a thickness of about 10 to 1000 nm. Note that, as described above, the electrode layer 4a0 may be made of a metal. In this case, the electrode layer 4a0 may be formed with, for example, a coating method.

As illustrated in FIG. 5, the electrode layer 4a0 is then separated into multiple sections of the first electrode layer 4a and the electrode layer 921. For example, the multiple first grooves P1 (first gaps G1) are formed to define the multiple sections of the first electrode layer 4a and the electrode layer 921. This forms, for example, first to fifth sections of the first electrode layer 4a and the electrode layer 921 aligned in a plane on the surface of the first substrate 3 in the first direction (positive X-direction). The multiple first grooves P1 (first gaps G1) may be formed by scribing such as laser scribing or mechanical scribing. Each of the first grooves P1 (each of the first gaps G1) may have its longitudinal direction parallel to the positive Y-direction. Each of the first grooves P1 (each of the first gaps G1) has a width of, for example, about 30 to 300 μm in the X-direction. The first grooves P1 have, for example, substantially the same length in the Y-direction as the cell areas 2.

Note that the first electrode layer 4a and the electrode layer 921 may be patterned at the same time as the film deposition. For example, the first electrode layer 4a and the electrode layer 921 may be formed by applying, with inkjet printing, a liquid material to an intended area of the first substrate 3 and drying the liquid material. Alternatively, the first electrode layer 4a and the electrode layer 921 may be formed on the first substrate 3 using a mask with patterned openings corresponding to the shapes of the multiple sections of the first electrode layer 4a and the electrode layer 921. This can eliminate a removal process such as scribing performed to form the first grooves P1. Note that the semiconductor layer 4b, the insulating layer 50, and the second electrode layer 4c (described later) may also be patterned at the same time as the film deposition, as with the first electrode layer 4a.

As illustrated in FIG. 6, a semiconductor layer 4b0 for a perovskite solar cell and an insulating layer 500 for the physical portion 5 are then formed on the multiple sections of the first electrode layer 4a.

For example, the semiconductor layer 4b0 is first formed over at least the entire first sub-areas 20a. The semiconductor layer 4b0 may be formed by, for example, applying and drying a liquid material with a coating method such as inkjet printing, spraying, bar coating, or die coating. In this example, the semiconductor layer 4b0 includes multiple layers including a perovskite semiconductor layer and an HTL stacked on each other. In this case, for example, a first liquid material may be applied and dried to form the perovskite semiconductor layer, and then a second liquid material may be applied and dried on the perovskite semiconductor layer to form the HTL. The semiconductor layer 4b0 may have, for example, a thickness of about 100 to 2000 nm. The semiconductor layer 4b0 is also in the first grooves P1 (first gaps G1) in the first sub-areas 20a.

The insulating layer 500 is then formed on the multiple sections of the first electrode layer 4a in areas adjacent to the semiconductor layer 4b0. The insulating layer 500 is formed over the entire second sub-areas 20b. The insulating layer 500 may be formed by, for example, applying and drying a liquid material with a coating method such as inkjet printing, spraying, bar coating, or die coating. The insulating layer 500 has, for example, substantially the same thickness as the semiconductor layer 4b0. The insulating layer 500 is also in the first grooves P1 (first gaps G1) in the second sub-areas 20b.

Note that the semiconductor layer 4b0 and the insulating layer 500 may be formed in the reverse order.

An example method for forming the semiconductor layer 4b0 and the insulating layer 500 with an inkjet printer will now be described. For example, the inkjet printer includes an inkjet head assembly, a feeder, a dryer, and a controller.

The inkjet head assembly includes one or more first inkjet heads that eject a liquid material of the semiconductor layer 4b0 and a second inkjet head that ejects a liquid material of the insulating layer 500. When the semiconductor layer 4b0 includes multiple semiconductor layers, the first inkjet heads eject liquid materials corresponding to the respective multiple semiconductor layers. The one or more first inkjet heads and the second inkjet head are aligned in a feeding direction of the first substrate 3. The first inkjet heads and the second inkjet head are elongated in a width direction perpendicular to the feeding direction, each including multiple outlets in the lower end surface. The multiple outlets are aligned at least in the width direction. A method for controlling the ejection of a liquid material through each of the outlets may be, for example, a piezoelectric method with which the liquid material is ejected with a voltage applied to piezo elements (piezoelectric elements) corresponding to each of the outlets or may be a thermal method with which the liquid material is ejected with heat generated through energizing heaters corresponding to each of the outlets.

The feeder moves the first substrate 3 relative to the inkjet head assembly in the feeding direction in a space below an inkjet assembly. The dryer includes, for example, a heater to heat the first substrate 3 to dry the liquid material. The dryer may be immediately downstream from each of the first inkjet heads and the second inkjet head in the feeding direction.

The controller controls the feeder, the inkjet head assembly, and the dryer. For example, the controller controls the feeder, the inkjet head assembly, and the dryer based on a program stored in a nonvolatile storage. The controller controls the feeder and the inkjet head assembly based on area data. The area data indicates areas of the first substrate 3 to which the semiconductor layer 4b0 and the insulating layer 500 are applied. The area data is set by, for example, an operator. For example, when an area of the first substrate 3 in which the semiconductor layer 4b0 is formed reaches a position immediately below the first inkjet head, the controller causes the first inkjet head to eject the liquid material through the outlets in the first inkjet head corresponding to the area, and causes the dryer to dry the liquid material. When the semiconductor layer 4b0 includes multiple semiconductor layers, the first inkjet heads perform application and the dryer performs drying multiple times. When an area of the first substrate 3 in which the insulating layer 500 is formed reaches a position immediately below the second inkjet head, the controller causes the second inkjet head to eject the liquid material through the outlets in the second inkjet head corresponding to the area. The dryer dries the liquid material as appropriate. The semiconductor layer 4b0 and the insulating layer 500 are thus formed on the first substrate 3.

An example method for forming the semiconductor layer 4b0 and the insulating layer 500 using a mask will now be described. For example, a first mask with openings corresponding to areas in which the semiconductor layer 4b0 is formed is placed on the first substrate 3. A liquid material of the semiconductor layer 4b0 is applied to the entire surface including the openings in the first mask. The liquid material is then dried. When the semiconductor layer 4b0 includes multiple semiconductor layers, the first mask is used to perform application and drying multiple times. The first mask is then removed, and a second mask with openings corresponding to areas in which the insulating layer 500 is formed is placed on the first substrate 3. A liquid material of the insulating layer 500 is then applied to the entire surface including the openings in the second mask. The liquid material is then dried.

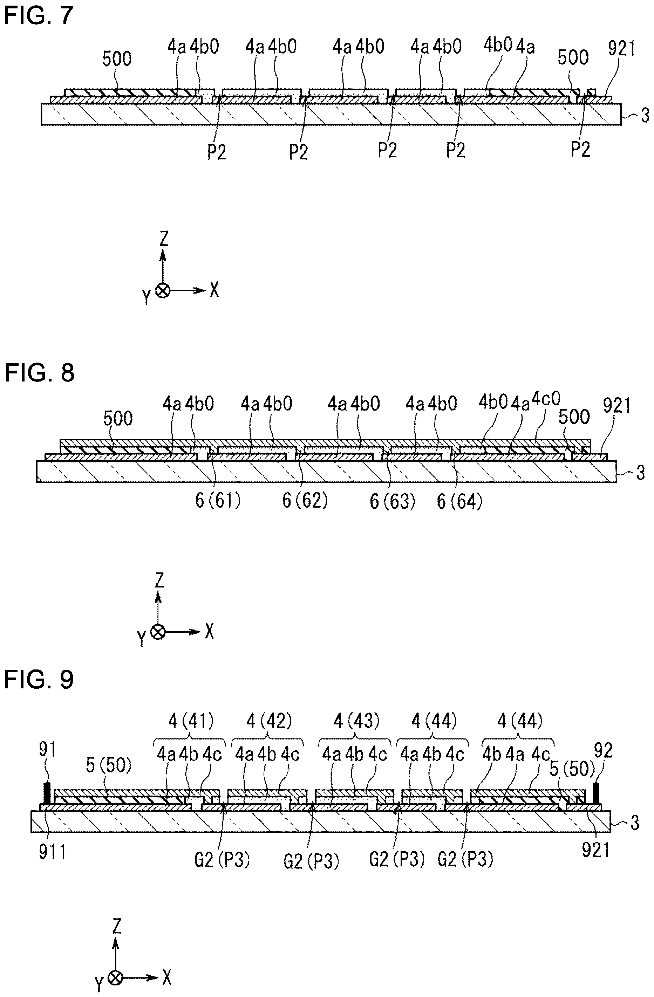

As illustrated in FIG. 7, the multiple second grooves P2 are then formed to connect the first electrode layer 4a and the second electrode layer 4c. The second grooves P2 may be formed by, for example, scribing. Each of the second grooves P2 extending in the positive Y-direction is formed in the semiconductor layer 4b0 and the insulating layer 500. Each of the second grooves P2 has a width of, for example, about 30 to 300 $\mu$m in the X-direction. The second grooves P2 have, for example, substantially the same length in the Y-direction as the cell areas 2.

As illustrated in FIG. 8, a second electrode layer 4c0 is then formed on the semiconductor layer 4b0 and the insulating layer 500 both including the second grooves P2. In this example, the second electrode layer 4c0 may be formed with, for example, a film deposition method such as sputtering, vapor deposition, or chemical vapor deposition. The second electrode layer 4c0 may be made of, for example, TCO such as ITO, FTO, or ZnO. The second electrode layer 4c0 may have, for example, a thickness of about 10 to 1000 nm. In this state, the second electrode layer 4c0 is in each of the second grooves P2. This forms the first connector 61, the second connector 62, the third connector 63, and the fourth connector 64. Note that, as described above, the second electrode layer 4c0 may be made of a metal. In this case, the second electrode layer 4c0 may be formed with, for example, a coating method.

As illustrated in FIG. 9, the second electrode layer 4c0 is then separated into multiple sections of the second electrode layer 4c. For example, the multiple third grooves P3 (second gaps G2) are formed to define the multiple sections of the second electrode layer 4c. The third grooves P3 may be formed by, for example, scribing. The semiconductor layer 4b0 is also appropriately separated into multiple sections of the semiconductor layer 4b. The insulating layer 500 is also separated into multiple sections of the insulating layer 50. The third grooves P3 are formed to define the multiple solar cell elements 4 that are connected in series to one another.

The first wiring 91 is then bonded to the end portion 911 at an end of the first electrode layer 4a in the negative X-direction, and the second wiring 92 is bonded to the electrode layer 921. For example, soldering is used to bond the first wiring 91 to the end portion 911 and the second wiring 92 to the electrode layer 921.

Subsequently, a sheet as a material of the filler 7 and the second substrate 8 are stacked in this order on the structure illustrated in FIG. 9. The components are then laminated together as an integral structure to be the solar cell module 1.

A frame (not illustrated) may be attached to the periphery of the first substrate 3 and the second substrate 8 as appropriate. The frame is a metal member or a resin member to achieve sealing between the first substrate 3 and the second substrate 8.

1-4. Overview of First Embodiment

In the solar cell module 1 according to the first embodiment, at least one of the multiple cell areas 2 includes the multiple sub-areas 20 having current densities different from one another. In the example in FIG. 1, each of the cell areas 2 includes the first sub-areas 20a and the second sub-areas 20b as the multiple sub-areas 20. In the above specific example, the first sub-areas 20a include the semiconductor layer 4b, and the second sub-areas 20b include the physical portion 5. The semiconductor layer 4b and the physical portion 5 have bandgap energy levels different from each other. In the above example, the physical portion 5 is the insulating layer 50, and thus the current density in the second sub-areas 20b is substantially zero. Thus, the first sub-areas 20a have a higher current density than the second sub-areas 20b.

The semiconductor layer 4b and the physical portion 5 having different bandgap energy levels have different degrees of absorbing incident light. Thus, the first sub-areas 20a and the second sub-areas 20b apparently show different colors. The first sub-areas 20a and the second sub-areas 20b showing different colors as described above can improve the design of the solar cell module 1.

In the above example, in each of the cell areas 2, the first sub-areas 20a are at least partially aligned with at least a part of the second sub-areas 20b in the Y-direction, and the first sub-areas 20a are at least partially aligned with at least a part of the second sub-areas 20b in the X-direction. Thus, the design on the solar cell module 1 can be two-dimensional. For example, in FIG. 1, the design areas indicating the sun, the cloud, and the smiling face correspond to the first sub-areas 20a, and the background areas surrounding the design areas correspond to the second sub-areas 20b. The user can thus visually identify the designs of the sun, the cloud, and the smiling face in the solar cell module 1.

In the above example, among the multiple cell areas 2, the second cell area 22 to the fourth cell area 24 in the middle portion also include the multiple sub-areas 20, in addition to the outer first cell area 21 and fifth cell area 25 in the X-direction. In this manner, at least one of the cell areas 2 in the middle portion includes the multiple sub-areas 20, allowing the design to be formed in areas that are more noticeable.

In the above example, the width W of each of the cell areas 2 is set to reduce a variation in the carrier generation amount among the multiple cell areas 2. Thus, the carriers generated in each of the cell areas 2 can be used more effectively to allow a direct current to flow through the multiple cell areas 2. In other words, the amount of carriers generated but not flowing as a direct current can be reduced.

In the example in FIG. 1, the multiple first sub-areas 20a are spaced apart from one another in each of the cell areas 2. For example, in the second cell area 22, the first sub-areas 20a as a part of the design area resembling the sun and the first sub-areas 20a as a part of the design area resembling the smiling face are spaced apart from one another across the second sub-areas 20b as the background area. Thus, each of the cell areas 2 includes multiple sections of the semiconductor layer 4b spaced apart from one another when viewed in plan, with the insulating layer 50 between the multiple sections of the semiconductor layer 4b.

In the above example, in each of the cell areas 2, the first electrode layer 4a and the second electrode layer 4c extend over the entire corresponding cell area 2. Thus, in each of the cell areas 2, surfaces of the multiple sections of the semiconductor layer 4b in the negative Z-direction are connected to the same section of the first electrode layer 4a, and surfaces of the multiple sections of the semiconductor layer 4b in the positive Z-direction are connected to the same section of the second electrode layer 4c (refer also to FIG. 3). Thus, with the multiple sections of the semiconductor layer 4b spaced apart from one another in each of the cell areas 2, the current generated by the multiple sections of the semiconductor layer 4b can appropriately flow to the first electrode layer 4a and the second electrode layer 4c. In other words, the multiple first sub-areas 20a spaced apart from one another in each of the cell areas 2 allow freely illustrating a design on the solar cell module 1, as well as allowing the current generated in each of the first sub-areas 20a to be output appropriately.

When the semiconductor layer 4b and the physical portion 5 are formed by inkjet printing, the shapes of the first sub-areas 20a and the shapes of the second sub-areas 20b can be easily changed. As described above, the inkjet printer includes the multiple outlets for ejecting the liquid material. The inkjet printer controls each of the outlets to eject or not to eject the liquid material, allowing the area to which the liquid material is applied to be changed easily. This structure facilitates design changes. More specifically, the operator may simply reset the area data.

1-5. Variations

In the above specific example, the semiconductor layer 4b is a perovskite semiconductor layer. However, the structure is not limited to this example. The semiconductor layer 4b may be another thin-film semiconductor other than the perovskite semiconductor. For example, various organic semiconductors other than the perovskite semiconductor may be used. Alternatively, a silicon-based, a compound-based, or another type of semiconductor may be used, for example. The silicon-based thin film semiconductor may be, for example, a semiconductor of amorphous silicon or thin film polycrystalline silicon. The compound-based thin film semiconductor may be, for example, a compound semiconductor with a chalcopyrite structure such as a CIS semiconductor or a CIGS semiconductor, a compound semiconductor with a kesterite structure, or a cadmium telluride (CdTe) semiconductor. The CIS semiconductor is a compound semiconductor containing copper (Cu), indium (In), and selenium (Se). The CIGS semiconductor is a compound semiconductor containing Cu, **In,** gallium (Ga), and Se. These thin-film semiconductors can be deposited on the first electrode layer 4a by, for example, vapor deposition. The semiconductor layer 4b may be patterned with, for example, laser scribing or mechanical scribing. The semiconductor layer 4b may be deposited in an intended area alone using a mask to eliminate the removal process such as scribing.

2. Second Embodiment

2-1. Structure of Solar Cell Module

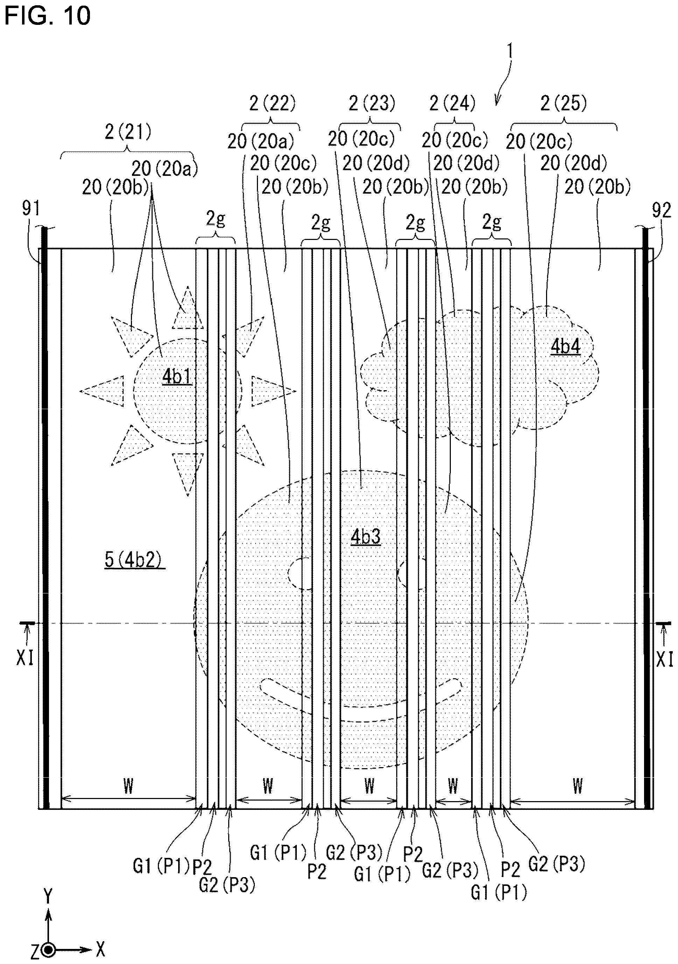

**In** the first embodiment, as illustrated in FIG. 10, first sub-areas 20a to fourth sub-areas 20d may be located as the multiple sub-areas 20 having different current densities. In the example in FIG. 10, the first sub-areas 20a correspond to a design area indicating a sun, the third sub-areas 20c correspond to a design area indicating a smiling face, the fourth sub-areas 20d correspond to a design area indicating a cloud, and the second sub-areas 20b correspond to the background area of these design areas.

As illustrated in FIG. 10, the first sub-areas 20a include a semiconductor layer 4b1 as the semiconductor layer 4b, the third sub-areas 20c include a semiconductor layer 4b3 as the semiconductor layer 4b, and the fourth sub-areas 20d include a semiconductor layer 4b4 as the semiconductor layer 4b. More specifically, the semiconductor layer 4b1 extends over the entire first sub-areas 20a, the semiconductor layer 4b3 extends over the entire third sub-areas 20c, and the semiconductor layer 4b4 extends over the entire fourth sub-areas 20d. The second sub-areas 20b include a semiconductor layer 4b2 as the physical portion 5. **In** other words, the semiconductor layer 4b2 extends over the entire second sub-areas 20b. The first to fourth sub-areas 20a to 20d are adjacent to one another when viewed in plan. Thus, the semiconductor layer 4b1 to the semiconductor layer 4b4 are at different positions when viewed in plan.

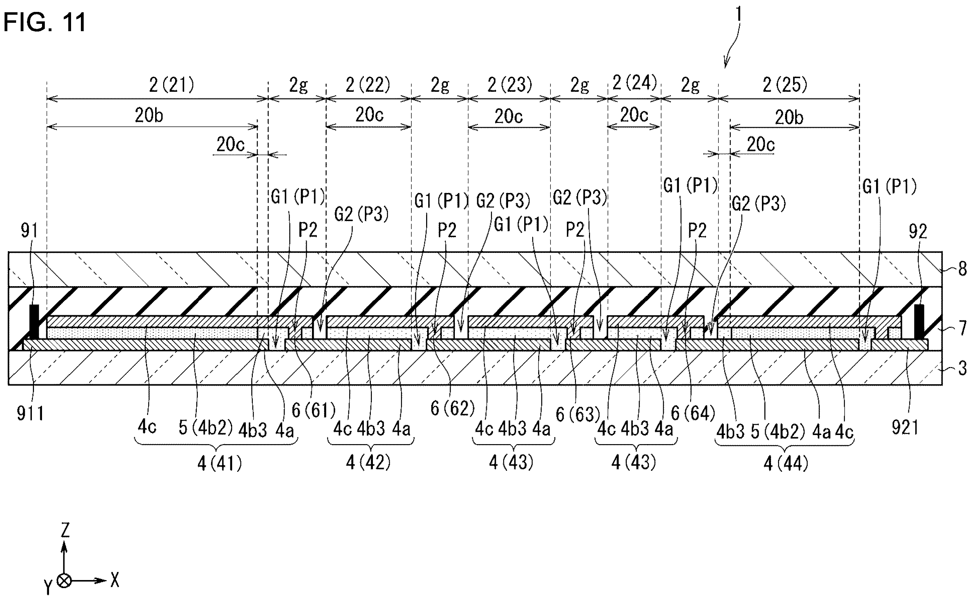

Each of the semiconductor layer 4b1 to the semiconductor layer 4b4 has the same structure as or a similar structure to the semiconductor layer 4b in the first embodiment. In a specific example, each of the semiconductor layer 4b1 to the semiconductor layer 4b4 includes, for example, a perovskite semiconductor layer and an HTL stacked on each other. As illustrated in FIG. 11, the semiconductor layer 4b2 as the physical portion 5 is also between the first electrode layer 4a and the second electrode layer 4c. The semiconductor layer 4b2 thus also functions as a part of the solar cell elements 4. More specifically, the semiconductor layer 4b2 as the physical portion 5 also generates a current in response to incident light. The current generated flows through the first electrode layer 4a, the semiconductor layer 4b2, and the second electrode layer 4c.

However, the semiconductor layer 4b1 to the semiconductor layer 4b4 have composition ratios different from one another in the perovskite semiconductor layer. In this example, a halide perovskite semiconductor is used as the perovskite semiconductor. For example, the material of the halide perovskite semiconductor may have a composition of $MAPb(I,Br)_3$ in which a methylammonium ion ($MA^+$), a lead ion ($Pb^{2+}$), and a halide ion ($I^-$, $Br^-$) are bonded. In this case, for example, when a value (also referred to as a Br content ratio x) divided by the sum of the I content and the Br content is increased, the bandgap energy level of the halide perovskite semiconductor increases from 1.5 to 2.3 eV. This allows, for example, the semiconductor layer 4b1 to the semiconductor layer 4b4 to apparently show colors changeable from a color close to black to a color close to yellow.

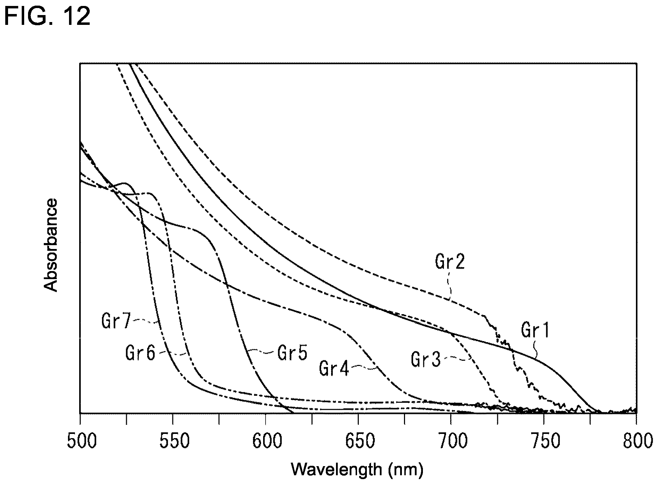

FIG. 12 shows the wavelength dependency of the absorbance in light-absorbing layers with the composition of $MAPb(I_{1-x}Br_x)_3$. In the example in FIG. 12, a curve GR1 to a curve GR7 are shown. The curve Gr1 to the curve Gr7 each indicate the absorbance in the corresponding light-absorbing layer when x = 0.0, 0.12, 0.26, 0.42, 0.59, 0.72, and 0.95, respectively. When x = 0.0, 0.12, 0.26, 0.42, 0.59, 0.72, and 0.95, the bandgap energy levels of the light-absorbing layers are 1.56, 1.62, 1.69, 1.79, 1.96, 2.01, and 2.23 eV, respectively. When x = 0.0, x = 0.12, or x = 0.26, higher absorbance is observed in a wide range of visible light (refer to the curve Gr1 to the curve Gr3 in FIG. 12). Thus, the color apparently shown is close to black. When x = 0.42 or x = 0.59, the apparent color is close to brown. When x = 0.72, the apparent color is close to red. When x = 0.95, the apparent color is close to yellow. As described above, a change in the Br content ratio x changes the color of the light-absorbing layer. When the difference in bandgap energy level between the light-absorbing layers is 0.1 or more, the difference in color between the light-absorbing layers can be substantially identified.

The perovskite semiconductor layers in the semiconductor layer 4b1 to the semiconductor layer 4b4 have Br content ratios x different from one another, with the difference in bandgap energy level of 0.1 or more. Note that the difference between a maximum value and a minimum value of the bandgap energy levels of the multiple semiconductor layers 4b may be, for example, 0.2 eV or more, or 0.5 eV or more. The bandgap energy level of at least one of the semiconductor layer 4b1 to the semiconductor layer 4b4 may be, for example, 1.7 eV or more.

In the second embodiment, the difference in bandgap energy level allows different apparent colors to be shown by the first sub-areas 20a with the semiconductor layer 4b1, the second sub-areas 20b with the semiconductor layer 4b2, the third sub-areas 20c with the semiconductor layer 4b3, and the fourth sub-areas 20d with the semiconductor layer 4b4. This further improves the design of the solar cell module 1.

2-2. Area Size of Cell Area

In the second embodiment as well, the width W of each of the cell areas 2 may be set as described below. More specifically, the width W of each of the cell areas 2 is set to achieve a smaller variation in the carrier generation amount than in an imaginary structure in which the multiple cell areas 2 have the same width. In a more specific example, the width W of each of the cell areas 2 is set to satisfy the formula below.

$$\Sigma(J[k, m]{\cdot}r[k, m]{\cdot}A[k]) = \text{constant} \qquad (2)$$

In this formula, $\Sigma(Z[m])$ is the sum of $Z[m]$ being the number of m-th sub-areas 20 (or the value of m) in each of the cell areas 2, $J[k, m]$ is the carrier generation amount per unit area and per unit time in the m-th sub-areas 20 in a k-th cell area 2, $A[k]$ is the area size of the k-th cell area 2, and $r[k, m]$ is the ratio of the area size of the m-th sub-areas 20 in the k-th cell area 2 to the area size A[k]. When each of the cell areas 2 is rectangular, the area size A[k] is the product of the length of the cell area 2 in the Y-direction and the width W of the cell area 2 in the X-direction. The left side of Formula 2 indicates the carrier generation amount in each of the cell areas 2. Thus, Formula 2 allows the width W of each of the cell areas 2 to be set to achieve a constant carrier generation amount among the multiple cell areas 2.

Note that each of the cell areas 2 with a larger area size ratio J[k, m] of the multiple sub-areas 20 with greater carrier generation amounts per unit area size and per unit time tends to have a smaller width W.

The width W of each of the cell areas 2 that is set as described above can reduce a variation in the carrier generation amount among the multiple cell areas 2. This allows the direct current to be output more efficiently from the solar cell module 1. In other words, this can improve the photoelectric conversion efficiency of the solar cell module 1.

Note that, although the semiconductor layer 4b1 to the semiconductor layer 4b4 are described in the above specific example, the number of types of semiconductor layers 4b with different composition ratios is not limited to four, and is any number that is two or more. The insulating layer 50 as the physical portion 5 and multiple types of semiconductor layers 4b may be adjacent to one another when viewed in plan. In the above example, although the multiple types of semiconductor layers 4b have the same composition with different composition ratios, multiple types of semiconductor layers 4b with different compositions may be adjacent to one another when viewed in plan.

3. Third Embodiment

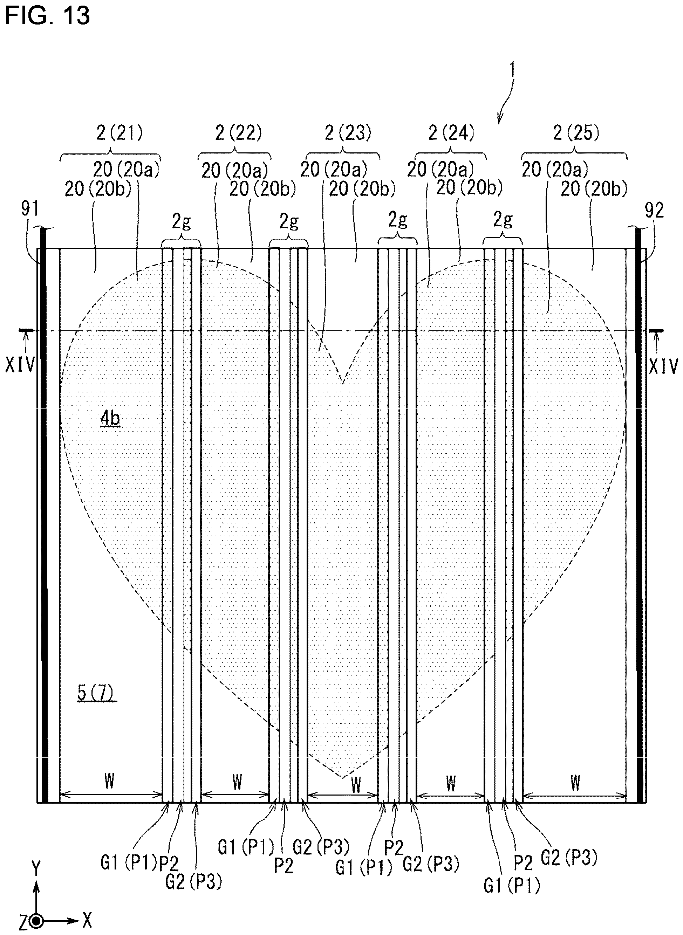

In the first embodiment, as illustrated in FIG. 13, each of the cell areas 2 may include a first sub-area 20a not separated into multiple areas. The first sub-area 20a may be continuous from an end of the corresponding cell area 2 in the negative X-direction to an end of the corresponding cell area 2 in the positive X-direction. In the example in FIG. 13, each of the cell areas 2 includes the first sub-area 20a and the second sub-areas 20b. In the example in FIG. 13, the first sub-area 20a corresponds to a design area resembling a heart, and the second sub-areas 20b correspond to the background area of the design area. In the example in FIG. 13, the first sub-area 20a is adjacent to the second sub-areas 20b in the Y-direction. The semiconductor layer 4b in the solar cell elements 4 extends over the entire first sub-area 20a. The physical portion 5 extends over the entire second sub-areas 20b. In this case, the physical portion 5 includes an insulator.

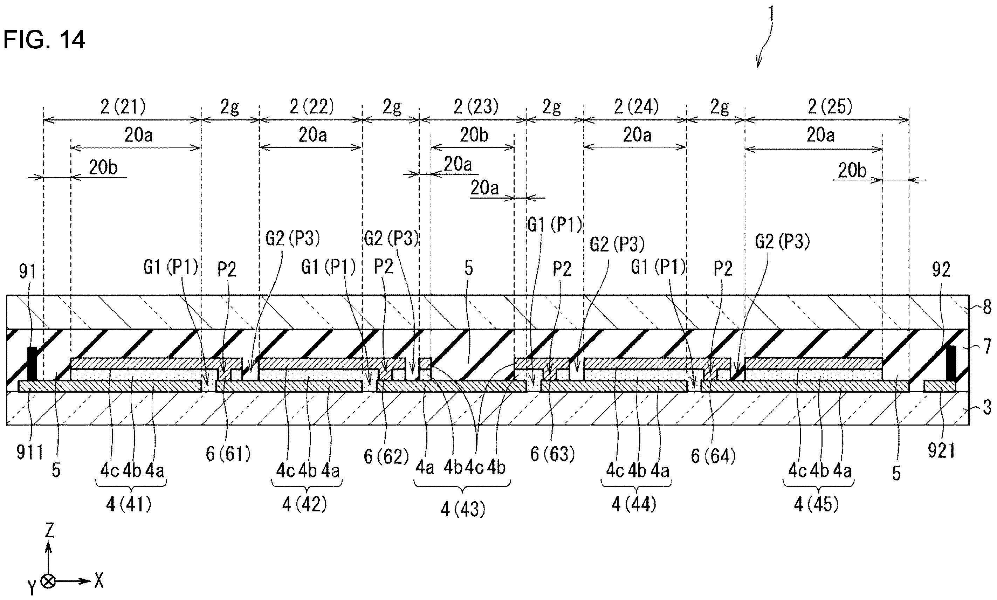

In this structure, as illustrated in FIGs. 14 to 16, at least one of the first electrode layer 4a or the second electrode layer 4c in the solar cell elements 4 may be outside the second sub-areas 20b. In other words, at least one of the first electrode layer 4a or the second electrode layer 4c may be outside the areas (the second sub-areas 20b) overlapping the physical portion 5 when viewed in plan.

In the example in FIG. 14, in each of the cell areas 2, the second electrode layer 4c is not in the second sub-areas 20b. In each of the cell areas 2, for example, a part of the filler 7 extends in the entire second sub-areas 20b. The part of the filler 7 in the second sub-areas 20b extends continuously from the surface of the first electrode layer 4a to the surface of the second substrate 8. The part of the filler 7 is also in contact with the side surfaces of the semiconductor layer 4b and the side surfaces of the second electrode layer 4c. In this structure, the physical portion 5 adjacent to the semiconductor layer 4b when viewed in plan corresponds to the part of the filler 7. The filler 7, which is an insulator, has a bandgap energy level different from the bandgap energy level of the semiconductor layer 4b. The first sub-area 20a and the second sub-areas 20b thus apparently show different colors. Thus, the design of the solar cell module 1 can be improved.

The first sub-area 20a with the semiconductor layer 4b is continuous from an end of each of the cell areas 2 in the negative X-direction to an end of the cell area 2 in the positive X-direction. Thus, the first electrode layer 4a and the second electrode layer 4c are also continuous from the end of each of the cell areas 2 in the negative X-direction to the end of the cell area 2 in the positive X-direction. Each section of the first electrode layer 4a extends beyond the end of the corresponding cell area 2 in the negative X-direction into the corresponding intercellular area 2g. Each section of the second electrode layer 4c extends beyond the end of the corresponding cell area 2 in the positive X-direction into the corresponding intercellular areas 2g. The connectors 6 electrically connect the first electrode layer 4a and the second electrode layer 4c in the intercellular areas 2g. The solar cell elements 4 in the multiple cell areas 2 can thus be connected in series to one another.

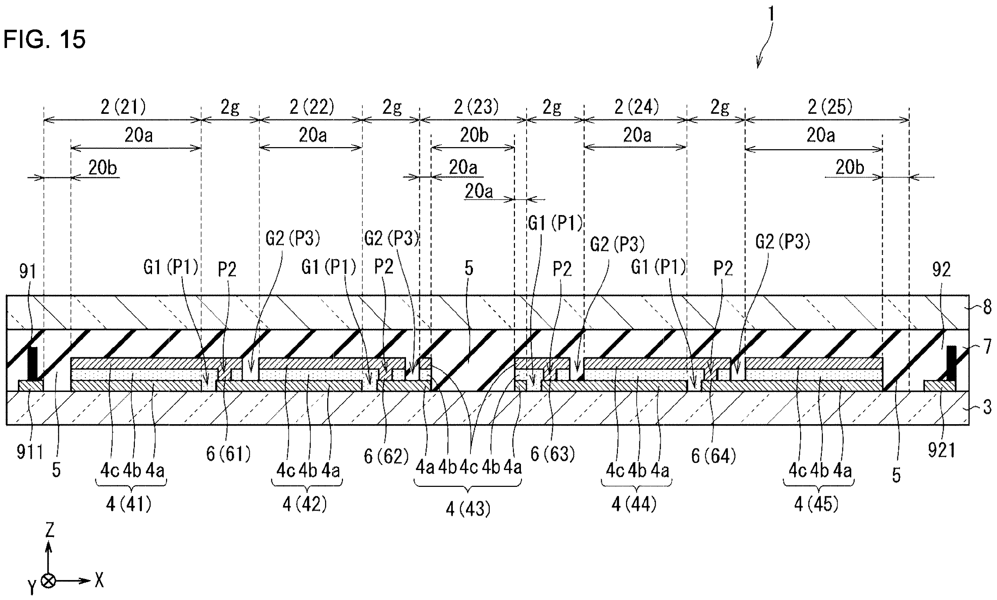

In the example in FIG. 15, in each of the cell areas 2, the first electrode layer 4a and the second electrode layer 4c are not in the second sub-areas 20b. In the example in FIG. 15 as well, in each of the cell areas 2, a part of the filler 7 is in the second sub-areas 20b. The part of the filler 7 in the second sub-areas 20b extends continuously from the surface of the first substrate 3 to the surface of the second substrate 8. The part of the filler 7 is also in contact with the side surfaces of the first electrode layer 4a, the side surfaces of the semiconductor layer 4b, and the side surfaces of the second electrode layer 4c. In this structure as well, the physical portion 5 adjacent to the semiconductor layer 4b when viewed in plan corresponds to the part of the filler 7. In this structure as well, the first sub-area 20a and the second sub-areas 20b apparently show different colors, improving the design of the solar cell module 1.

In the examples in FIGs. 14 and 15, the physical portion 5 is a part of the filler 7. The physical portion 5 and the filler 7 are thus not located separately from each other, reducing the manufacturing cost of the solar cell module 1.

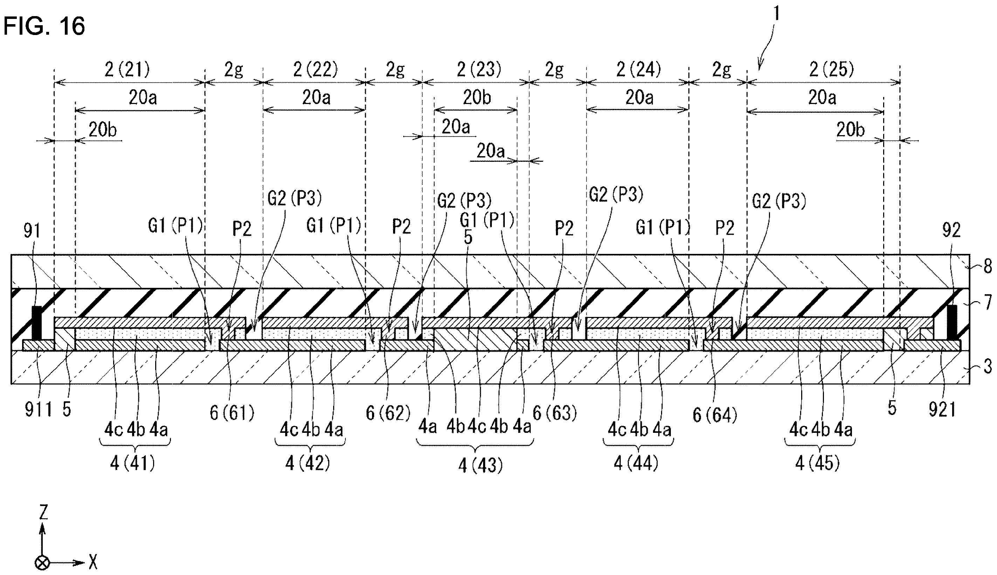

In the example in FIG. 16, in each of the cell areas 2, the first electrode layer 4a is not in the second sub-areas 20b. The physical portion 5 extends over the entire second sub-areas 20b in each of the cell areas 2. The physical portion 5 is adjacent to and in the same layer as the first electrode layer 4a and the semiconductor layer 4b. The physical portion 5 is, for example, in contact with the side surfaces of the first electrode layer 4a and the side surfaces of the semiconductor layer 4b.

The second electrode layer 4c extends over the entire first sub-area 20a and the entire second sub-areas 20b in each of the cell areas 2. More specifically, the second electrode layer 4c is on the semiconductor layer 4b and the physical portion 5. The physical portion 5 supports the second electrode layer 4c together with the semiconductor layer 4b.

The physical portion 5 may be, for example, the insulating layer 50 or a semiconductor layer having a bandgap energy level different from the bandgap energy level of the semiconductor layer 4b. Thus, the first sub-area 20a and the second sub-areas 20b apparently show different colors, improving the design of the solar cell module 1.

4. Fourth Embodiment

4-1. Absorber

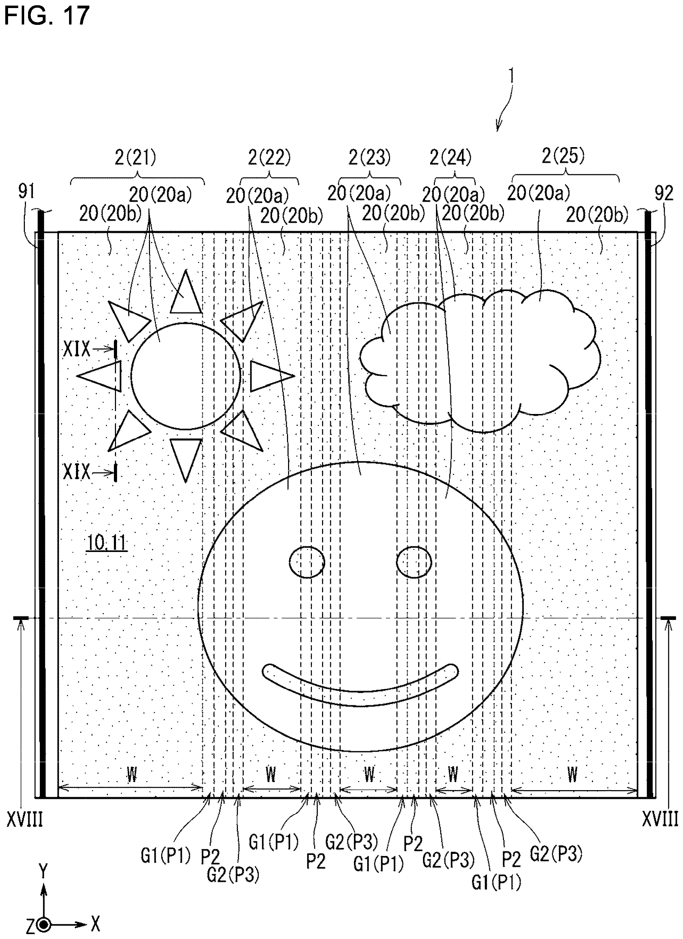

In the first embodiment, as illustrated in FIGs. 17 to 19, each of the cell areas 2 in the solar cell module 1 may include no physical portion 5 and include the solar cell element 4. In other words, in each of the cell areas 2, the first electrode layer 4a, the semiconductor layer 4b, and the second electrode layer 4c may be stacked on one another over the entire cell area 2.

In the example in FIGs. 17 to 19, the solar cell module 1 also includes an absorber 10. The absorber 10 extends, for example, over the entire second sub-areas 20b without extending in the first sub-areas 20a. In other words, the absorber 10 is outside the first sub-areas 20a. In the example in FIG. 17 as well, the first sub-areas 20a correspond to the design area, and the second sub-areas 20b correspond to the background area. The absorber 10 is, for example, a plate with its thickness direction parallel to the normal of a surface 3a of the first substrate 3. The surface 3a is opposite to a surface of the first substrate 3 adjacent to the solar cell elements 4.

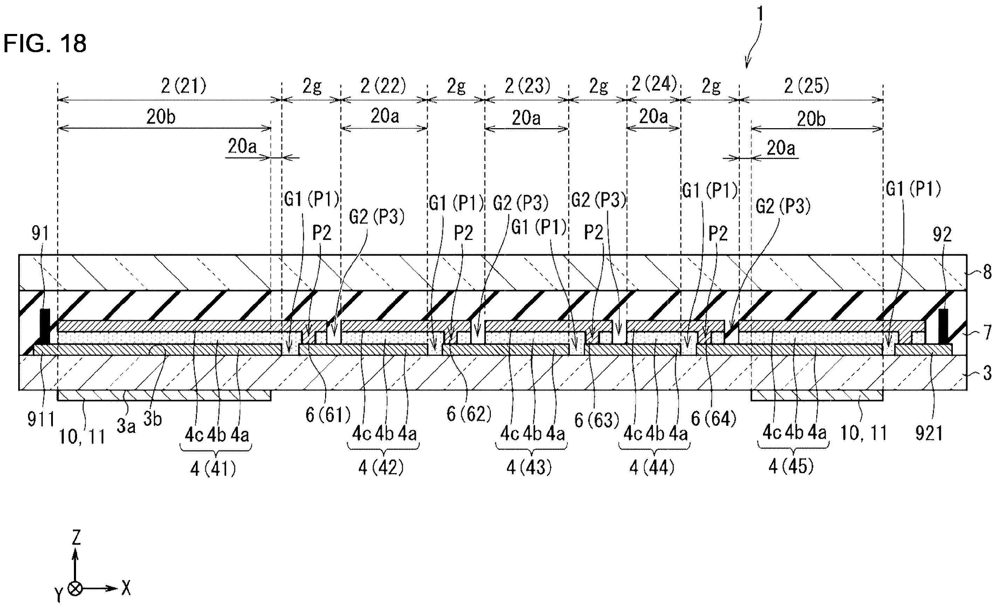

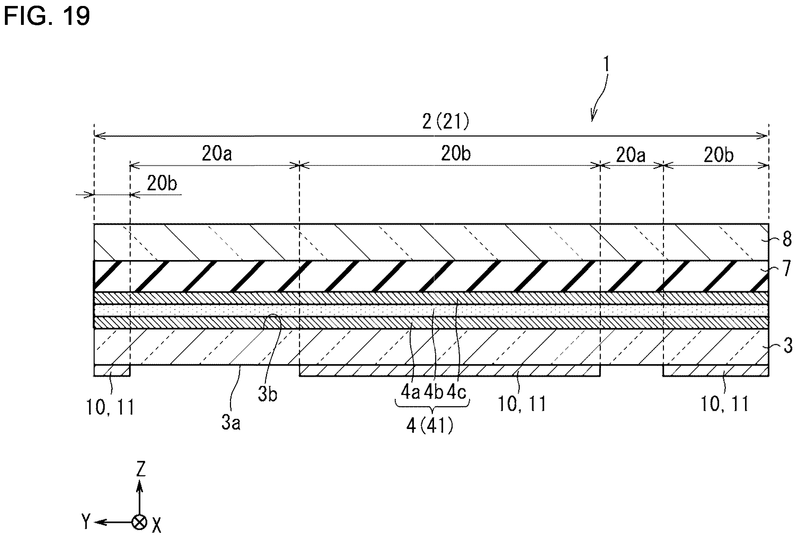

The absorber 10 is, for example, closer to the light source than the light-absorbing layer in the semiconductor layer 4b. In this example, the solar cell module 1 is installed with the first substrate 3 facing the light source. In the example in FIGs. 18 and 19, the absorber 10 is on the surface 3a of the first substrate 3.

The absorber 10 absorbs, of the incident light, a portion with at least a partial wavelength range of the incident light. The wavelength range of light absorbed by the absorber 10 includes a partial or the entire wavelength range of the visible light. The peak absorptivity of the absorber 10 for light in the wavelength range may be, for example, 30% or more, 50% or more, 70% or more, or 90% or more. The absorber 10 may be, for example, a coating film being colored transparent or opaque. Alternatively, the absorber 10 may contain a colored substance such as a pigment or a dye that absorbs light. Alternatively, the absorber 10 may be a semiconductor layer that absorbs light in a partial or the entire wavelength range of visible light.

The absorber 10 may be formed on the surface 3a of the first substrate 3 with, for example, a film deposition method such as coating, vapor deposition, sputtering, chemical vapor deposition, or plating. The absorber 10 may be patterned by, for example, etching with laser or plasma or by mechanical scribing. Alternatively, the absorber 10 may be deposited using a mask or by inkjet printing to eliminate the removal process such as etching or scribing.

Alternatively, the absorber 10 may also be formed on a substrate such as a transparent film. In this case, the substrate may be bonded to the surface 3a of the first substrate 3.

In each of the cell areas 2, the first electrode layer 4a, the semiconductor layer 4b, and the second electrode layer 4c in the solar cell element 4 may extend over the entire cell area 2. In other words, each of the first electrode layer 4a, the semiconductor layer 4b, and the second electrode layer 4c is, for example, a strip with its longitudinal direction parallel to the positive Y-direction when viewed in plan. The first electrode layer 4a, the semiconductor layer 4b, and the second electrode layer 4c each have, for example, substantially the same length in the Y-direction as the cell areas 2. Each section of the first electrode layer 4a extends beyond the end of the corresponding cell area 2 in the negative X-direction into the corresponding intercellular area 2g. Each section of the semiconductor layer 4b and each section of the second electrode layer 4c extend beyond the end of the corresponding cell area 2 in the positive X-direction into the corresponding intercellular area 2g. In each of the intercellular areas 2g, the connector 6 electrically connects the first electrode layer 4a and the second electrode layer 4c. The multiple solar cell elements 4 may thus be connected in series with one another. The light-absorbing layer in the semiconductor layer 4b is, for example, a perovskite semiconductor layer. The Br content ratio x in the light-absorbing layer may be, for example, 0.4 or more. In this case, the solar cell elements 4 can generate power in response to light in a wavelength range absorbed by the absorber 10.

In the second sub-areas 20b, incident light such as sunlight transmitted through the absorber 10 and the first substrate 3 is incident on the solar cell elements 4. In contrast, in the first sub-areas 20a, incident light transmitted through the first substrate 3 without through the absorber 10 is incident on the solar cell elements 4. Thus, the amount of light incident on the semiconductor layer 4b in the first sub-areas 20a differs from the amount of light incident on the semiconductor layer 4b in the second sub-areas 20b. In this example, the absorber 10 is in the second sub-areas 20b. The first sub-areas 20a thus receive more light than the second sub-areas 20b.

Thus, the current generated by the solar cell elements 4 in the first sub-areas 20a has a higher current density than the current generated by the solar cell elements 4 in the second sub-areas 20b. In the fourth embodiment as well, each of the cell areas 2 includes the multiple sub-areas 20 having different current densities.

In the fourth embodiment, as described above, the absorber 10 extends over the entire second sub-areas 20b without extending in the first sub-areas 20a. In other words, each of the cell areas 2 includes the multiple sub-areas 20 having different absorptivity spectra (or spectral absorptivity values) for incident light. Thus, the multiple sub-areas 20, or for example, the first sub-areas 20a and the second sub-areas 20b, apparently show different colors. Thus, the design of the solar cell module 1 can be improved.

In the above example, among the multiple cell areas 2, the second cell area 22 to the fourth cell area 24 in the middle portion include the multiple sub-areas 20, in addition to the outer first cell area 21 and the fifth cell area 25 in the X-direction. In this manner, at least one of the cell areas 2 in the middle portion includes the multiple sub-areas 20, allowing the design to be formed in areas that are more noticeable.

As illustrated in FIG. 17, the cell areas 2 may have different widths W. More specifically, the widths W of the cell areas 2 may be set to reduce a variation in the carrier generation amount. In other words, the width W of each of the cell areas 2 may be set to achieve a smaller variation in the carrier generation amount among the multiple cell areas 2 than in an imaginary structure in which the multiple cell areas 2 have the same width. In a more specific example, the widths W of the cell areas 2 may be determined using Formula 2.

The widths W of the cell areas 2 set as described above can reduce a variation in the carrier generation amount among the multiple cell areas 2. This allows the direct current to be output more efficiently from the solar cell module 1.

In the above example, the absorber 10 is on the surface 3a of the first substrate 3. In other words, the absorber 10 is not between the first electrode layer 4a and the second electrode layer 4c in the solar cell elements 4. Thus, a direct current flowing through the solar cell elements 4 does not flow through the absorber 10. The absorber 10 thus does not obstruct power generation in the solar cell elements 4 and is less likely to decrease the photoelectric conversion efficiency of the solar cell module 1.

#### 4-1-1. First Variation

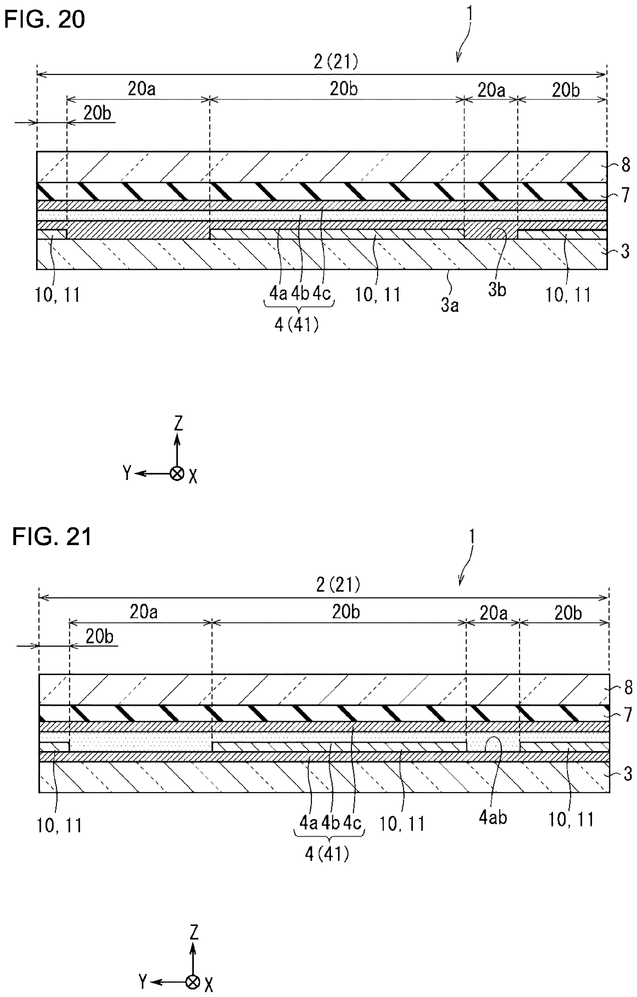

As illustrated in FIG. 20, the absorber 10 may be on a surface 3b of the first substrate 3. The surface 3b is opposite to the surface 3a of the first substrate 3. In the example in FIG. 20, the first electrode layer 4a is on the first substrate 3 and the absorber 10. The absorber 10 is, for example, between and covered by the first substrate 3 and the first electrode layer 4a in each of the cell areas 2.

Note that the absorber 10 may be inside the first substrate 3. For example, when the first substrate 3 includes multiple insulating layers, the absorber 10 may be between any two of the insulating layers.

#### 4-1-2. Second Variation

As illustrated in FIG. 21, the absorber 10 may be on a surface 4ab of the first electrode layer 4a. The surface 4ab is a surface of the first electrode layer 4a adjacent to the semiconductor layer 4b. Thus, the absorber 10 is between and covered by the first electrode layer 4a and the semiconductor layer 4b in each of the cell areas 2.

#### 4-1-3. Third Variation

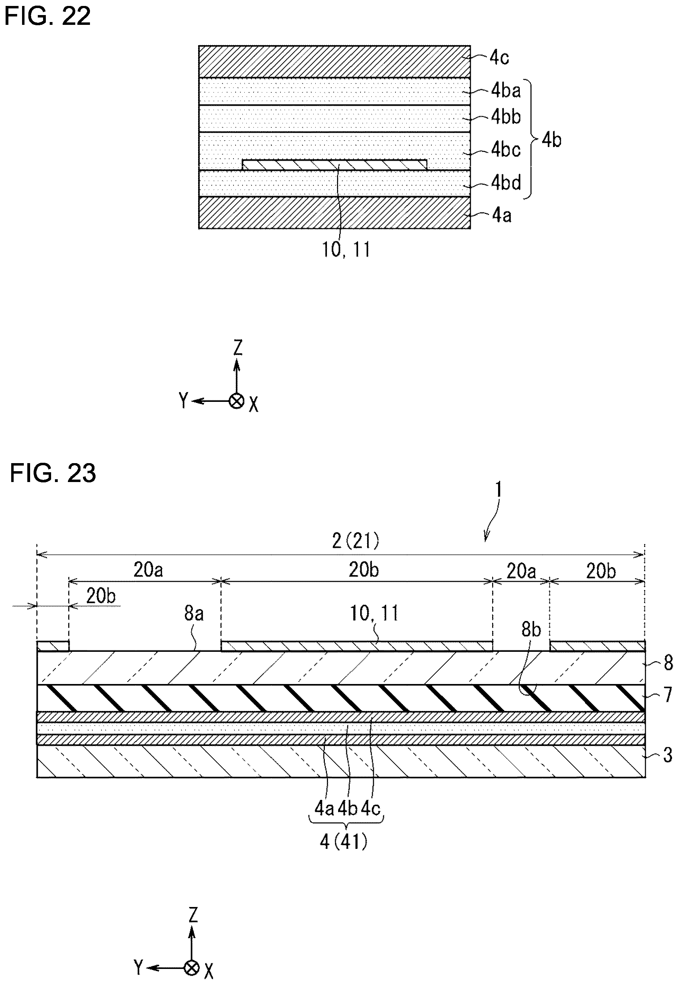

As illustrated in FIG. 22, the absorber 10 may be inside the semiconductor layer 4b. In the example in FIG. 22, the semiconductor layer 4b is a multilayered semiconductor film including a semiconductor layer 4ba to a semiconductor layer 4bd. In this example, the semiconductor layer 4bd is on the first electrode layer 4a, the semiconductor layer 4bc is on the semiconductor layer 4bd, the semiconductor layer 4bb is on the semiconductor layer 4bc, the semiconductor layer 4ba is on the semiconductor layer 4bb, and the second electrode layer 4c is on the semiconductor layer 4ba. The semiconductor layer 4bb is the light-absorbing layer. The absorber 10 is located closer to the light source, or in other words, closer to the first substrate 3 than the semiconductor layer 4bb. In the example in FIG. 22, the absorber 10 is on a surface of the semiconductor layer 4bd closer to the second electrode layer 4c. The semiconductor layer 4bc is on the semiconductor layer 4bd and the absorber 10. The absorber 10 is between and covered by the semiconductor layer 4bc and the semiconductor layer 4bd in each of the cell areas 2.

Note that the number of layers in the semiconductor layer 4b may be changed as appropriate. In other words, the absorber 10 is closer to the light source than the light-absorbing layer in the semiconductor layer 4b including any number of layers.

#### 4-1-4. Fourth Variation

The solar cell module 1 with the second substrate 8 facing the light source will now be described. As illustrated in FIG. 23, the absorber 10 may be on a surface 8a of the second substrate 8. The surface 8a is opposite to a surface of the second substrate 8 adjacent to the filler 7.

4-1-5. Fifth Variation

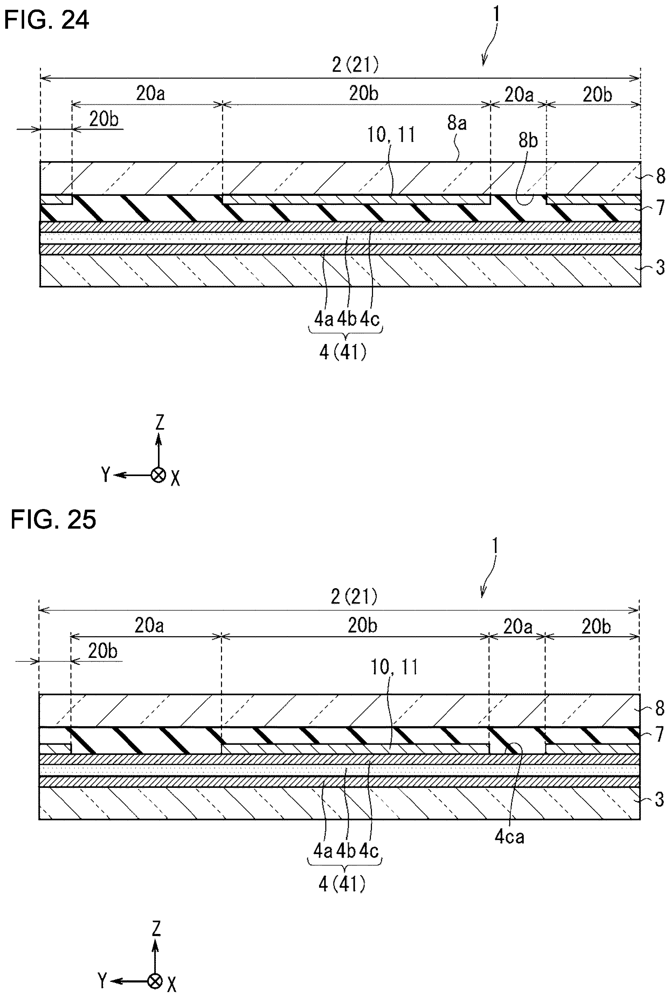

As illustrated in FIG. 24, the absorber 10 may be on a surface 8b of the second substrate 8. The surface 8b of the second substrate 8 is opposite to the surface 8a. The filler 7 is bonded to the second substrate 8 and the absorber 10. The absorber 10 is between and covered by the second substrate 8 and the filler 7.

Note that the absorber 10 may be inside the second substrate 8. For example, when the second substrate 8 includes multiple insulating layers, the absorber 10 may be between any two of the insulating layers.

4-1-6. Sixth Variation

As illustrated in FIG. 25, the absorber 10 may be on a surface 4ca of the second electrode layer 4c. The surface 4ca is opposite to a surface of the second electrode layer 4c adjacent to the semiconductor layer 4b. The filler 7 is bonded to the solar cell elements 4 and the absorber 10. The absorber 10 is between and covered by the filler 7 and the second electrode layer 4c.

In the first variation to the sixth variation as well, the absorber 10 extends over the entire second sub-areas 20b when viewed in plan without extending in the first sub-areas 20a. Thus, the first sub-areas 20a and the second sub-areas 20b apparently show different colors. Thus, the design of the solar cell module 1 can be improved.

In the first variation to the third variation, the fifth variation, and the sixth variation, the absorber 10 is between the first substrate 3 and the second substrate 8, allowing the absorber 10 to be protected from the external space. This maintains the design of the solar cell module 1 for a longer period.

In the first variation, the second variation, and the fourth variation to the sixth variation, the absorber 10 is not between the first electrode layer 4a and the second electrode layer 4c. Thus, the direct current does not flow through the absorber 10.

4-1-7. Others

Although the absorber 10 is located in the second sub-areas 20b alone in the above example, the absorber 10 may be located in the first sub-areas 20a alone. In this case as well, the design of the solar cell module 1 can be improved. Multiple types of absorbers 10 with different absorptivity spectra may be located dispersedly when viewed in plan. In other words, three or more types of sub-areas 20 may be included. For example, the multiple types of absorbers 10 showing different apparent colors may be located in the respective types of multiple sub-areas 20. For example, with reference to FIG. 10, each of the different absorbers 10 may be in the respective first sub-areas 20a to the fourth sub-areas 20d. This further improves the design of the solar cell module 1.

4-2. Reflector

In the first embodiment, as illustrated in FIGs. 17 to 19, the solar cell module 1 may include a reflector 11. In other words, the reflector 11 may replace the absorber 10. For example, the reflector 11 extends, for example, over the entire second sub-areas 20b without extending in the first sub-areas 20a. In other words, the reflector 11 is outside the first sub-areas 20a. In the example in FIGs. 18 and 19, the reflector 11 is on the surface 3a of the first substrate 3. The reflector 11 is, for example, a plate with a thickness direction parallel to the normal of the surface 3a of the first substrate 3.

The reflector 11 reflects, of the incident light, a portion with at least a partial wavelength range of the incident light. The wavelength range of light reflected from the reflector 11 includes a partial or the entire wavelength range of visible light. A peak reflectivity of the reflector 11 for light in the wavelength range may be, for example, 30% or more, 50% or more, 70% or more, or 90% or more. The reflector 11 may be, for example, a metal film. Alternatively, the reflector 11 may contain a colored substance such as a pigment or a dye that reflects light. Alternatively, the reflector 11 may be a semiconductor layer that reflects light in a partial or in the entire wavelength range of visible light. Note that the reflector 11 may absorb a portion of visible light. In this case, the reflector 11 may be a reflective absorber.

The reflector 11 may be formed on the surface 3a of the first substrate 3 with, for example, a film deposition method such as coating, vapor deposition, sputtering, chemical vapor deposition, or plating. The reflector 11 may be patterned by, for example, etching with laser or plasma or by mechanical scribing. Alternatively, the reflector 11 may be deposited using a mask or by inkjet printing to eliminate the removal process such as etching or scribing.

Alternatively, the reflector 11 may also be formed on a substrate such as a transparent film. In this case, the substrate may be bonded to the surface 3a of the first substrate 3.

The reflector 11 reflects incident light such as sunlight in the second sub-areas 20b. When the reflector 11 reflects most of incident light, almost no light is incident on areas facing the second sub-areas 20b in the solar cell elements 4. When the reflector 11 transmits a portion of incident light, the portion of incident light is incident on the solar cell elements 4. In contrast, in the first sub-areas 20a, the incident light transmitted through the first substrate 3 is incident on the solar cell elements 4. Thus, the amount of light incident on the semiconductor layer 4b in the first sub-areas 20a differs from the amount of light incident on the semiconductor layer 4b in the second sub-areas 20b. In this example, the first sub-areas 20a receive more light than the second sub-areas 20b.

The solar cell elements 4 can generate power in response to light in a wavelength range reflected from the reflector 11. Thus, the current generated by the solar cell elements 4 in the first sub-areas 20a has a higher current density than the current generated by the solar cell elements 4 in the second sub-areas 20b. In other words, each of the cell areas 2 includes the multiple sub-areas 20 with different current densities.

As described above, the reflector 11 extends over the entire second sub-areas 20b without extending in the first sub-areas 20a. In other words, each of the cell areas 2 includes the multiple sub-areas 20 with different reflectivity spectra (or spectral reflectivity values) for the incident light. Thus, the multiple sub-areas 20, or for example, the first sub-areas 20a and the second sub-areas 20b, apparently show different colors. Thus, the design of the solar cell module 1 can be improved.

Note that, for the structure including the reflector 11, the widths W of the cell areas 2 are set to reduce a variation in the carrier generation amount in the multiple cell areas 2. This allows the direct current to be output more efficiently from the solar cell module 1. 4-2-1. Other Variations

Other variations for the position of the reflector 11 are the same as or similar to the position of the absorber 10, as illustrated in FIGs. 20 to 25. In any of the variations, the reflector 11 extends over the second sub-areas 20b without extending in the first sub-areas 20a. The first sub-areas 20a and the second sub-areas 20b can thus apparently show different colors.

Note that the reflector 11 may be located opposite to the light source with respect to the light-absorbing layer in the solar cell elements 4. However, this structure increases the amount of light incident on the solar cell elements 4 in the second sub-areas 20b. For example, in FIG. 23, the incident light transmitted through the first substrate 3, the solar cell element 4, the filler 7, and the second substrate 8 in the second sub-area 20b is incident on the reflector 11. The incident light is then reflected from the reflector 11, transmitted through the second substrate 8 and the filler 7, and is incident on the solar cell element 4 again. Thus, the amount of light incident on the solar cell element 4 in the second sub-areas 20b is greater than the amount of light incident on the solar cell element 4 in the first sub-areas 20a. The second sub-areas 20b thus have a higher current density than the first sub-areas 20a. In other words, the relationship in level of current density is opposite to such a relationship in the structure in FIG. 17. The widths W of the cell areas 2 are set to reduce a variation in carrier generation amount among the multiple cell areas 2. Thus, the relationship in the size of the widths W among the cell areas 2 is opposite to the relationship in the size of the widths W among the cell areas 2 in the structure in FIG. 17.

4-2-2. Others

Although the reflector 11 is located in the second sub-areas 20b alone in the above example, the reflector 11 may be located in the first sub-areas 20a alone. In this case as well, the design of the solar cell module 1 can be improved. Multiple types of reflectors 11 with different reflectivity spectra may be located dispersedly when viewed in plan. For example, the multiple types of reflectors 11 showing different apparent colors may be located in the respective multiple types of sub-areas 20. This further improves the design of the solar cell module 1.

The absorber 10 and the reflector 11 may both be included when viewed in plan. In other words, each of the cell areas 2 may include the multiple types of sub-areas 20 with at least one of the absorptivity spectrum or the reflectivity spectrum different among the multiple types of sub-areas 20.

The solar cell elements 4 may include the reflector 11. For example, the second electrode layer 4c may be made of a metal to function as the reflector 11. In this case, the second electrode layer 4c may be located in, for example, the first sub-areas 20a alone. Thus, the first sub-areas 20a and the second sub-areas 20b apparently show different colors. This also improves the design of the solar cell module 1.

Although the solar cell module 1 has been described in detail, the above structures are illustrative in all respects, and the structure of the solar cell module 1 is not limited to the above structures. Many examples other than those illustrated above may also be implemented without departing from the scope of the present disclosure. The components described in the above embodiments and variations may be combined or eliminated as appropriate unless any contradiction arises.

The components described in the above embodiments may be entirely or partially combined as appropriate unless any contradiction arises.

The present disclosure provides the structures described below.

(1) **In** one embodiment, a solar cell module includes a plurality of cell areas and a connector. The plurality of cell areas is aligned in a first direction in a plane. Each of the plurality of cell areas includes a solar cell element that generates power in response to incident light. The connector electrically connects, in series, the solar cell element in a cell area of the plurality of cell areas to the solar cell element in another cell area of the plurality of cell areas. The solar cell element includes a first electrode layer, a second electrode layer, and a semiconductor layer between the first electrode layer and the second electrode layer. At least one of the plurality of cell areas includes a physical portion adjacent to the semiconductor layer when viewed in plan. The physical portion includes an insulator or a semiconductor having a bandgap energy level different from a bandgap energy level of the semiconductor layer.

(2) In the solar cell module according to (1), the physical portion may be between the first electrode layer and the second electrode layer in the at least one of the plurality of cell areas.

(3) In the solar cell module according to (2), the physical portion may include a semiconductor having a bandgap energy level different from the bandgap energy level of the semiconductor layer.

(4) In the solar cell module according to any one of (1) to (3), the semiconductor layer in the at least one of the plurality of cell areas may include a first semiconductor layer and a second semiconductor layer having bandgap energy levels different from each other. The first semiconductor layer and the second semiconductor layer may be at different positions when viewed in plan.

(5) In the solar cell module according to any one of (1) to (4), the physical portion in the at least one of the plurality of cell areas may be adjacent to the semiconductor layer at least in a second direction perpendicular to the first direction.

(6) In the solar cell module according to any one of (1) to (5), the semiconductor layer in the at least one of the plurality of cell areas may be continuous between two ends of the at least one of the plurality of cell areas in the first direction. At least one of the first electrode layer or the second electrode layer in the at least one of the plurality of cell areas may be outside an area overlapping the physical portion when viewed in plan.

(7) The solar cell module according to (6) may further include a first substrate on which the solar cell element is located, a second substrate facing the first substrate, and an insulating filler between the first substrate and the second substrate. The insulating filler may cover the solar cell element. The second electrode layer may be closer to the second substrate than the semiconductor layer. The second electrode layer in the at least one of the plurality of cell areas may be outside an area overlapping the physical portion when viewed in plan. The physical portion may be a part of the insulating filler.

(8) In the solar cell module according to (1) or (2), the physical portion may include an insulator. The at least one of the plurality of cell areas may include a first cell area and a second cell area. The physical portion may have a larger area size in the first cell area than in the second cell area when viewed in plan. The first cell area may have a greater width than the second cell area in the first direction.

(9) In another embodiment, a solar cell module includes a plurality of cell areas, a connector, and a member. The plurality of cell areas is aligned in a first direction in a plane. Each of the plurality of cell areas includes a solar cell element that generates power in response to incident light. The connector electrically connects, in series, the solar cell element in a cell area of the plurality of cell areas to the solar cell element in another cell area of the plurality of cell areas. The member overlaps a first area in at least one of the plurality of cell areas and does not overlap a second area in the at least one of the plurality of cell areas when viewed in plan. The member absorbs, of the incident light, a portion with at least a partial wavelength range of the incident light.

(10) In another embodiment, a solar cell module includes a plurality of cell areas, a connector, and a member. The plurality of cell areas is aligned in a first direction in a plane. Each of the plurality of cell areas includes a solar cell element that generates power in response to incident light. The connector electrically connects, in series, the solar cell element in a cell area of the plurality of cell areas to the solar cell element in another cell area of the plurality of cell areas. The member overlaps a first area in at least one of the plurality of cell areas excluding outer two cell areas of the plurality of cell areas in the first direction and does not overlap a second area in the at least one of the plurality of cell areas when viewed in plan. The member reflects, of the incident light, a portion with at least a partial wavelength range of the incident light.

(11) The solar cell module according to (9) or (10) may further include a first substrate on which the solar cell element is located. The member may be on the first substrate or inside the first substrate.

(12) The solar cell module according to (9) or (10) may further include a first substrate on which the solar cell element is located, a second substrate facing the first substrate, and a filler between the first substrate and the second substrate. The filler may cover the solar cell element. The member may be on the second substrate or inside the second substrate.

(13) In the solar cell module according to (9) or (10), the member may be on the solar cell element or inside the solar cell element.

(14) In the solar cell module according to any one of (1), (2), (9), and (10), widths of the plurality of cell areas in the first direction may be set to have a smaller variation in an amount of carriers generated per unit time among the plurality of cell areas than in an imaginary structure in which the plurality of cell areas has a same width.

REFERENCE SIGNS

1 solar cell module
2, 21 to 25 cell area
21 first cell area (cell area)
22 second cell area (cell area)
3 first substrate

4, 41 to 45 solar cell element
4a first electrode layer
4b semiconductor layer
4b1 first semiconductor layer (semiconductor layer)
4b2 second semiconductor layer (semiconductor layer)
4c second electrode layer
5 physical portion
50 insulating layer
6, 61 to 64 connector
7 filler
8 second substrate
10 member (absorber)
11 member (reflector)

**Claims**

1. A solar cell module, comprising:

   a plurality of cell areas aligned in a first direction in a plane, each of the plurality of cell areas including a solar cell element configured to generate power in response to incident light; and
   a connector electrically connecting, in series, the solar cell element in a cell area of the plurality of cell areas to the solar cell element in another cell area of the plurality of cell areas,
   wherein the solar cell element includes a first electrode layer, a second electrode layer, and a semiconductor layer between the first electrode layer and the second electrode layer, and
   at least one of the plurality of cell areas includes a physical portion adjacent to the semiconductor layer when viewed in plan, and the physical portion includes an insulator or a semiconductor having a bandgap energy level different from a bandgap energy level of the semiconductor layer.

2. The solar cell module according to claim 1, wherein the physical portion is between the first electrode layer and the second electrode layer in the at least one of the plurality of cell areas.

3. The solar cell module according to claim 2, wherein the physical portion includes a semiconductor having a bandgap energy level different from the bandgap energy level of the semiconductor layer.

4. The solar cell module according to any one of claims 1 to 3, wherein

   the semiconductor layer in the at least one of the plurality of cell areas includes a first semiconductor layer and a second semiconductor layer having bandgap energy levels different from each other, and

the first semiconductor layer and the second semiconductor layer are at different positions when viewed in plan.

5. The solar cell module according to any one of claims 1 to 4, wherein
   the physical portion in the at least one of the plurality of cell areas is adjacent to the semiconductor layer at least in a second direction perpendicular to the first direction.

6. The solar cell module according to any one of claims 1 to 5, wherein

   the semiconductor layer in the at least one of the plurality of cell areas is continuous between two ends of the at least one of the plurality of cell areas in the first direction, and
   at least one of the first electrode layer or the second electrode layer in the at least one of the plurality of cell areas is outside an area overlapping the physical portion when viewed in plan.

7. The solar cell module according to claim 6, further comprising:

   a first substrate on which the solar cell element is located;
   a second substrate facing the first substrate; and
   an insulating filler between the first substrate and the second substrate, the insulating filler covering the solar cell element,
   wherein the second electrode layer is closer to the second substrate than the semiconductor layer,
   the second electrode layer in the at least one of the plurality of cell areas is outside an area overlapping the physical portion when viewed in plan, and
   the physical portion is a part of the insulating filler.

8. The solar cell module according to claim 1 or claim 2, wherein

   the physical portion includes an insulator,
   the at least one of the plurality of cell areas includes a first cell area and a second cell area,
   the physical portion has a larger area size in the first cell area than in the second cell area when viewed in plan, and
   the first cell area has a greater width than the second cell area in the first direction.

9. A solar cell module, comprising:

   a plurality of cell areas aligned in a first direction in a plane, each of the plurality of cell areas including a solar cell element configured to generate power in response to incident light;

a connector electrically connecting, in series, the solar cell element in a cell area of the plurality of cell areas to the solar cell element in another cell area of the plurality of cell areas; and

a member overlapping a first area in at least one of the plurality of cell areas and not overlapping a second area in the at least one of the plurality of cell areas when viewed in plan, the member being configured to absorb, of the incident light, a portion with at least a partial wavelength range of the incident light.

10. A solar cell module, comprising:

a plurality of cell areas aligned in a first direction in a plane, each of the plurality of cell areas including a solar cell element configured to generate power in response to incident light;

a connector electrically connecting, in series, the solar cell element in a cell area of the plurality of cell areas to the solar cell element in another cell area of the plurality of cell areas; and

a member overlapping a first area in at least one of the plurality of cell areas excluding outer two cell areas of the plurality of cell areas in the first direction and not overlapping a second area in the at least one of the plurality of cell areas when viewed in plan, the member being configured to reflect, of the incident light, a portion with at least a partial wavelength range of the incident light.

11. The solar cell module according to claim 9 or claim 10, further comprising:

a first substrate on which the solar cell element is located,

wherein the member is on the first substrate or inside the first substrate.

12. The solar cell module according to claim 9 or claim 10, further comprising:

a first substrate on which the solar cell element is located;

a second substrate facing the first substrate; and

a filler between the first substrate and the second substrate, the filler covering the solar cell element,

wherein the member is on the second substrate or inside the second substrate.

13. The solar cell module according to claim 9 or claim 10, wherein

the member is on the solar cell element or inside the solar cell element.

14. The solar cell module according to any one of claims 1, 2, 9, and 10, wherein

widths of the plurality of cell areas in the first direction are set to have a smaller variation in an amount of carriers generated per unit time among the plurality of cell areas than in an imaginary structure in which the plurality of cell areas has a same width.

FIG. 1

FIG. 2

EP 4 535 968 A1

FIG. 3

EP 4 535 968 A1

# FIG. 4

4a0

3

Z
Y⊗ →X

# FIG. 5

4a    4a    4a    4a    4a    921

3

G1(P 1)  G1(P 1)  G1(P 1) G1(P1)    G1(P1)

Z
Y⊗ →X

# FIG. 6

500    4a    4a 4b0    4a    4a    4a  500  921

3

G1(P1)   G1(P1)    G1(P1) G1(P1)    G1(P1)

Z
Y⊗ →X

FIG. 7

FIG. 8

FIG. 9

FIG. 10

FIG. 11

FIG. 12

FIG. 13

EP 4 535 968 A1

FIG. 14

FIG. 15

FIG. 16

FIG. 17

FIG. 18

FIG. 19

EP 4 535 968 A1

FIG. 20

FIG. 21

## FIG. 22

## FIG. 23

FIG. 24

FIG. 25

# EP 4 535 968 A1

## INTERNATIONAL SEARCH REPORT

| International application No. |
|---|
| **PCT/JP2023/017170** |

| A. | CLASSIFICATION OF SUBJECT MATTER |
|---|---|

*H10K 39/12*(2023.01)i; *H10K 30/40*(2023.01)i; *H10K 30/88*(2023.01)i
FI:    H10K39/12; H10K30/40; H10K30/88

According to International Patent Classification (IPC) or to both national classification and IPC

| B. | FIELDS SEARCHED |
|---|---|

Minimum documentation searched (classification system followed by classification symbols)

H10K30/00-39/18; H01L31/046-31/0468

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580 (JDreamIII)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2013-506995 A (LG INNOTEK CO., LTD.) 28 February 2013 (2013-02-28)<br>    paragraphs [0024]-[0323], fig. 1-36 | 1-2, 5-14 |
| X | WO 02/052654 A1 (KK HAYASHIBARA SEIBUTSU KAGAKU KENKYUJO) 04 July 2002 (2002-07-04)<br>    page 10, line 8 to page 12, line 11, fig. 1, 2 | 1-4, 9-10, 13-14 |
| Y | | 1-5, 8 |
| Y | JP 2018-125359 A (SEIKO EPSON CORP.) 09 August 2018 (2018-08-09)<br>    paragraphs [0019]-[0080] | 1-5, 8 |
| A | JP 2012-28738 A (DAINIPPON PRINTING CO., LTD.) 09 February 2012 (2012-02-09) | 1-14 |
| A | JP 2016-58445 A (SHARP CORP.) 21 April 2016 (2016-04-21) | 1-14 |
| A | JP 2002-343998 A (SHARP CORP.) 29 November 2002 (2002-11-29) | 1-14 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **22 June 2023** | **11 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/017170**

| Patent document cited in search report | | | Publication date (day/month/year) | Patent family member(s) | | | Publication date (day/month/year) |
|---|---|---|---|---|---|---|---|
| JP | 2013-506995 | A | 28 February 2013 | US 2012/0186625 A1 paragraphs [0025]-[0342], fig. 1-36 WO 2011/040786 A2 EP 2485273 A2 KR 10-2011-0036375 A KR 10-2011-0036170 A CN 102668120 A | | | |
| WO | 02/052654 | A1 | 04 July 2002 | US 2004/0074531 A1 paragraphs [0021]-[0023], fig. 1, 2 EP 1357607 A1 | | | |
| JP | 2018-125359 | A | 09 August 2018 | US 2018/0217561 A1 paragraphs [0027]-[0088] | | | |
| JP | 2012-28738 | A | 09 February 2012 | US 2013/0074904 A1 WO 2011/162038 A1 CN 102947966 A | | | |
| JP | 2016-58445 | A | 21 April 2016 | (Family: none) | | | |
| JP | 2002-343998 | A | 29 November 2002 | (Family: none) | | | |

Form PCT/ISA/210 (patent family annex) (January 2015)

40

**EP 4 535 968 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022085267 A

- JP 2007012976 A